# EUROPEAN PATENT APPLICATION

(11) **EP 2 048 700 A2**
(43) Date of publication of application: **15.04.2009**
(21) Application number: 08166504.4
(22) Date of filing: 13.10.2008
(51) Int. Cl.: H01L 21/027, H01L 21/311, H01L 21/316, H01L 21/318

(54) **Antireflective coatings**

(30) Priority: 12.10.2007 US 979585 P; 02.10.2008 US 244426
(71) Applicant: Air Products and Chemicals, Inc., Allentown, PA 18195-1501 (US)
(72) Inventor: Vrtis, Raymond Nicholas, Orefield, PA 18069 (US); O'Neill, Mark Leonard, Allentown, PA 18104 (US); Johnson, Andrew David, Doylestown, PA 18901 (US)
(74) Representative: Muir, Benjamin M. J.

(57) **Abstract**

A method of forming a feature in a substrate comprising the steps of: forming a dielectric layer on a substrate; forming an antireflective coating over the dielectric layer; forming a photoresist pattern over the antireflective coating; etching the dielectric layer through the patterned photoresist; and removing the antireflective coating and the photoresist, wherein the antireflective coating is a film represented by the formula SiᵥO_{w}CₓNᵤH_{y}F_{z}, wherein v+w+x+u+y+z = 100%, v is from 1 to 35 atomic%, w is from 1 to 65 atomic%, x is from 5 to 80 atomic%, u is from 0 to 50 atomic %, y is from 10 to 50 atomic% and z is from 0 to 15 atomic%, wherein the antireflective coating is formed by the chemical vapor deposition of a composition comprising (1) at least one precursor selected from an organosilane, an organosiloxane, and an aminosilane; and (2) a hydrocarbon, and wherein the hydrocarbon is substantially not removed from the antireflective coating.

## Description

### BACKGROUND OF THE INVENTION

The present invention relates to a method for making a semiconductor device. More particularly, the present invention relates to methods of forming antireflective coating (ARC) layers on silicon and dielectric materials as well as the resulting integrated circuit precursor structures.

To meet the requirements for faster performance, the characteristic dimensions of features of integrated circuit devices have continued to be decreased. Manufacturing of devices with smaller feature sizes introduces new challenges in many of the processes conventionally used in semiconductor fabrication. The escalating requirements for high-density and performance associated with ultra large-scale integration semiconductor wiring require responsive changes in interconnect technology. Such escalating requirements have been found difficult to satisfy in terms of providing a low RC (resistance capacitance) interconnect pattern, particularly where sub-micron via contacts and trenches have high aspect ratios imposed by miniaturization. Efforts to ameliorate the deleterious effects of increased component densities and decreased interconnect cross-sections include the use of insulating materials with lower dielectric constants than typical oxide insulators ("low k materials"), and the use of conducting materials with higher conductivity than typical aluminum (Al) conductors. Copper is emerging as the leading material for use as the on-chip conductor in typical present-generation interconnects (ICs).

Copper (Cu), however, presents challenges to precise patterning and etching. For example, Cu does not readily form volatile chlorides or fluorides, rendering typical plasma etching based upon chlorine and/or fluorine chemistries impractically slow.
Thus, subtractive patterning of Cu, in which a Cu layer is selectively etched away below a patterned layer of photoresist, has been largely replaced by "damascene" or "dual damascene" patterning. The resulting IC structures or features are referred to as damascene or dual damascene structures or features.

Problems can occur in the patterning and the fabrication of features in ICs as a result of reflection of the exposing radiation from the surface (or surfaces) lying below the layer of photoresist. For example, interferences of incident and reflected radiation occurring within the layer of photoresist lead to non-uniform photoresist exposure and imprecise patterning. In addition, exposing radiation can reflect from surface topography or regions of non-uniform reflectivity resulting in exposure of photoresist in regions lying beneath the photomask and for which exposure is not desired. In both cases, variations in the feature critical dimensions ("CDs") can occur, adding to the challenges of precise and reproducible fabrication of IC features.

A common practice to eliminate or reduce fabrication problems resulting from radiation reflection is the use of anti-reflective coatings. For example, Bottom-Antireflective-Coatings ("BARCs") are commonly applied beneath the photoresist layer, lying on the surface to be patterned. BARC layers may be designed to absorb radiation that penetrates the layer of photoresist and, by this mechanism, reduce or eliminate the deleterious effects of reflections from the underlying surface. In addition, BARC layers may be designed through choice of BARC material and thickness such that, at the wavelength of the exposing radiation, destructive interference occurs between incident and reflected radiation. Both absorptive and destructive interference effects may be used in the same BARC layer.

Light absorbing organic polymers have been developed that are formed into antireflective coating (ARC) compositions and are applied beneath a photoresist layer in order to reduce the reflectivity normally encountered from the semiconductor substrates during the photoresist DUV exposure. These organic ARCs are typically applied to the semiconductor substrates by a process called spin-coating. Although spin-coated ARC layers offer excellent reflectivity control, their performance is limited by their nonuniformity, defectivity and conformability constrictions, and other inefficiencies inherent within the spin-coating process. As the industry approaches adoption of eight-inch or even twelve-inch semiconductor substrates, the inherent inefficiencies of the spin-coating process will become increasingly magnified.

The art has addressed the inherent inefficiencies of the spin-coating process by providing light absorbing organic polymers that are applied by a chemical vapor deposition (CVD) process. For example, U.S. Patent No. 6,936,405 discloses depositing by CVD an antireflective compound on a substrate surface wherein the antireflective compound is a highly strained (e.g., having a strain energy of at least about 10 kcal/mol) organic molecule comprising two cyclic moieties joined to one another via a linkage group. The CVD process comprises heating the antireflective compound to vaporize it, and then pyrolizing the vaporized compound to form stable diradicals which are subsequently polymerized on a substrate surface in a deposition chamber.

Light absorbing organic polymers, however, irrespective of their means of deposition have significant drawbacks. For *example,* although such organic polymers have very good light absorbing characteristics, the films of such materials are often mechanically, chemically, or thermally unsound and they often do not properly adhere to the typically inorganic substrate upon which they are formed. Therefore, there is a need in the art for antireflective polymer films that are applied by CVD that do not suffer from the afore-mentioned drawbacks.

### BRIEF SUMMARY OF THE INVENTION

The present invention provides a method and composition for forming an organic-inorganic composite film that have a desirable balance between light absorption, etch selectivity, and structural integrity.

In particular, the present invention provides a method of forming a feature in a substrate comprising the steps of: forming a dielectric layer on a substrate; forming an antireflective coating over the dielectric layer; forming a photoresist pattern over the antireflective coating; etching the dielectric layer through the patterned photoresist; and removing the antireflective coating and the photoresist; wherein the antireflective coating is a film represented by the formula SiᵥO_{w}CₓNᵤH_{y}F_{z}, wherein v+w+x+u+y+z = 100%, v is from 1 to 35 atomic%, w is from 1 to 65 atomic%, x is from 5 to 80 atomic%, u is from 0 to 50 atomic %, y is from 10 to 50 atomic% and z is from 0 to 15 atomic%; wherein the antireflective coating is formed by the chemical vapor deposition of a composition comprising (1) at least one precursor selected from an organosilane, an organosiloxane, and an aminosilane, and (2) a hydrocarbon; and preferably wherein the hydrocarbon is substantially not removed from the antireflective coating.

In another aspect, the present invention provides a structure formed during manufacture of a semiconductor device, the structure comprising: a patternable layer, for example a dielectric layer, formed above a substrate; an antireflective coating formed over the patternable layer, wherein the antireflective coating is represented by the formula SiᵥO_{w}CₓNᵤH_{y}F_{z}, wherein v+w+x+u+y+z = 100%, v is from 1 to 35 atomic%, w is from 1 to 65 atomic%, x is from 5 to 80 atomic%, u is from 0 to 50 atomic %, y is from 10 to 50 atomic% and z is from 0 to 15 atomic%; and a photoresist pattern formed over the antireflective coating; wherein the antireflective coating is formed by the chemical vapor deposition of (1) at least one precursor selected from an organosilane, an organosiloxane, and an aminosilane, and (2) a hydrocarbon; and preferably wherein the hydrocarbon is substantially not removed from the antireflective coating.

In the above aspects, v may more preferably be from 10 to 35 atomic %, and/or w may more preferably be from 1 to 40, 5 to 65 or 5 to 40 atomic%. Thus, in one embodiment of the above aspects, the antireflective coating may be a film represented by the formula SiᵥO_{w}CₓNᵤH_{y}F_{z}, wherein v+w+x+u+y+z = 100%, v is from 1 to 35 atomic%, w is from 1 to 40 atomic%, x is from 5 to 80 atomic%, u is from 0 to 50 atomic%, y is from 10 to 50 atomic% and z is from 0 to 15 atomic%. In another embodiment, the antireflective coating may be represented by the formula SiᵥO_{w}CₓNᵤH_{y}F_{z}, wherein v+w+x+u+y+z = 100%, v is from 10 to 35 atomic%, w is from 5 to 65 atomic%, x is from 5 to 80 atomic%, u is from 0 to 50 atomic%, y is from 10 to 50 atomic% and z is from 0 to 15 atomic%.

Preferably, the dielectric layer is porous.

The antireflective coating may, for example be a hardmask.

In one embodiment, the antireflective coating is formed by the chemical vapor deposition of a composition comprising an aminosilane and a hydrocarbon. The aminosilane may, for example, be bis(tertiarybutylamino)silane.

The hydrocarbon may be distinct from the at least one precursor.

In one embodiment, the at least one precursor is at least one selected from:
(a) the formula R¹ₙ(OR²)ₚ(O(O)CR³)₄₋₍ₙ₊ₚ₎Si where R¹ is independently H or C₁ to C₄ linear or branched, saturated, singly or multiply unsaturated, cyclic, partially or fully fluorinated hydrocarbon; R² is independently C₁ to C₆ linear or branched, saturated, singly or multiply unsaturated, cyclic, aromatic, partially or fully fluorinated hydrocarbon; R³ is independently H, C₁ to C₆ linear or branched, saturated, singly or multiply unsaturated, cyclic, aromatic, partially or fully fluorinated hydrocarbon; n is 0 to 4; p is 0 to 4; and n+p ≤ 4
(b) the formula R¹(OR²)ₚ(O(O)CR⁴)₃₋ₙ₋ₚSi-O-SiR³ₘ(O(O)CR⁵)_{q}(OR⁶)_{3-m-q} where R¹ and R³ are independently H or C₁ to C₄ linear or branched, saturated, singly or multiply unsaturated, cyclic, partially or fully fluorinated hydrocarbon; R² and R⁶ are independently C₁ to C₆ linear or branched, saturated, singly or multiply unsaturated, cyclic, aromatic, partially or fully fluorinated hydrocarbon; R⁴ and R⁵ are independently H, C₁ to C₆ linear or branched, saturated, singly or multiply unsaturated, cyclic, aromatic, partially or fully fluorinated hydrocarbon; n is 0 to 3; m is 0 to 3; q is 0 to 3; and p is 0 to 3, provided that n+p ≤ 3 and m+q ≤ 3;
(c) the formula R¹ₙ(OR²)ₚ(O(O)CR⁴)₃₋ₙ₋ₚSi-SiR³ₘ(O(O)CR⁵)_{q}(OR⁶)_{3-m-q} where R¹ and R³ are independently H or C₁ to C₄ linear or branched, saturated, singly or multiply unsaturated, cyclic, partially or fully fluorinated hydrocarbon; R²and R⁶ are independently C₁ to C₆ linear or branched, saturated, singly or multiply unsaturated, cyclic, aromatic, partially or fully fluorinated hydrocarbon; R⁴ and R⁵ are independently H, C₁ to C₆ linear or branched, saturated, singly or multiply unsaturated, cyclic, aromatic, partially or fully fluorinated hydrocarbon; n is 0 to 3; m is 0 to 3; q is 0 to 3; and p is 0 to 3, provided that n+p ≤ 3 and m+q ≤ 3;
(d) the formula R¹ₙ(OR²)ₚ(O(O)CR⁴)₃₋ₙ₋ₚSi-R⁷-SiR³ₘ(O(O)CR⁵)_{q}(OR⁶)_{3-m-q} where R¹ and R³ are independently H or C₁ to C₄ linear or branched, saturated, singly or multiply unsaturated, cyclic, partially or fully fluorinated hydrocarbon; R², R⁶ and R⁷ are independently C₁ to C₆ linear or branched, saturated, singly or multiply unsaturated, cyclic, aromatic, partially or fully fluorinated hydrocarbon, alternatively, R⁷ is an amine or an organoamine group; R⁴ and R⁵ are independently H, C₁ to C₆ linear or branched, saturated, singly or multiply unsaturated, cyclic, aromatic, partially or fully fluorinated hydrocarbon; n is 0 to 3; m is 0 to 3; q is 0 to 3; and p is 0 to 3, provided that n+p ≤ 3, and m+q ≤ 3;
(e) the formula (R¹ₙ(OR²)p(O(O)CR³)₃₋₍ₙ₊ₚ₎Si)ₜCH₄₋ₜ where R¹ is independently H or C₁ to C₄ linear or branched, saturated, singly or multiply unsaturated, cyclic, partially or fully fluorinated hydrocarbon; R² is independently C₁ to C₆ linear or branched, saturated, singly or multiply unsaturated, cyclic, aromatic, partially or fully fluorinated hydrocarbon; R³ is independently H, C₁ to C₆ linear or branched, saturated, singly or multiply unsaturated, cyclic, aromatic, partially or fully fluorinated hydrocarbon; n is 0 to 3; p is 0 to 3; and t is 2 to 4, provided that n+p ≤ 3;
(f) the formula (R¹ₙ(OR²)ₚ(O(O)CR³)₃₋₍ₙ₊ₚ₎Si)ₜNH₃₋ₜ where R¹ is independently H or C₁ to C₄ linear or branched, saturated, singly or multiply unsaturated, cyclic, partially or fully fluorinated hydrocarbon; R² is independently C₁ to C₆ linear or branched, saturated, singly or multiply unsaturated, cyclic, aromatic, partially or fully fluorinated hydrocarbon; R³ is independently H, C₁ to C₆ linear or branched, saturated, singly or multiply unsaturated, cyclic, aromatic, partially or fully fluorinated hydrocarbon; n is 0 to 3; p is 0 to 3; and t is 1 to 3, provided that n+p ≤ 3;
(g) cyclic siloxanes of the formula (OSiR¹R³)ₓ, where R¹ and R³are independently H or C₁ to C₄, linear or branched, saturated, singly or multiply unsaturated, cyclic, partially or fully fluorinated hydrocarbon; x is an integer from 2 to 8;
(h) cyclic silazanes of the formula (NR¹SiR¹R³)ₓ, where R¹ and R³are independently H or C₁ to C₄, linear or branched, saturated, singly or multiply unsaturated, cyclic, partially or fully fluorinated hydrocarbon; and x is an integer from 2 to 8;
(i) cyclic carbosilanes of the formula (CR¹R³SiR¹R³)ₓ, where R¹ and R³are independently H or C₁ to C₄, linear or branched, saturated, singly or multiply unsaturated, cyclic, partially or fully fluorinated hydrocarbon; and x is an integer from 2 to 8;
(k) the formula R¹ₙ(OR²)ₚ(NR³_{z})ₖ₍ₙ₊ₚ₎Si where R¹ is independently H or C₁ to C₄ linear or branched, saturated, singly or multiply unsaturated, cyclic, partially or fully fluorinated hydrocarbon; R² is independently C₁ to C₆ linear or branched, saturated, singly or multiply unsaturated, cyclic, aromatic, partially or fully fluorinated hydrocarbon; R³ is independently H, C₁ to C₆ linear or branched, saturated, singly or multiply unsaturated, cyclic, aromatic, partially or fully fluorinated hydrocarbon; z is 1 or 2; n is 0 to 3; and p is 0 to 3;
(l) the formula R¹ₙ(OR²)ₚ(NR⁴_{z})₃₋ₙ₋ₚSi-O-SiR³ₘ(NR⁵_{z})_{q}(OR⁶)_{3-m-q} where R¹ and R³ are independently H or C₁ to C₄ linear or branched, saturated, singly or multiply unsaturated, cyclic, partially or fully fluorinated hydrocarbon; R² and R⁶ are independently C₁ to C₆ linear or branched, saturated, singly or multiply unsaturated, cyclic, aromatic, partially or fully fluorinated hydrocarbon; R⁴ and R⁵ are independently H, C₁ to C₆ linear or branched, saturated, singly or multiply unsaturated, cyclic, aromatic, partially or fully fluorinated hydrocarbon; z is 1 or 2; n is 0 to 3; m is 0 to 3; q is 0 to 3; and p is 0 to 3, provided that n+p ≤ 3 and m+q ≤ 3;
(m) the formula R¹ₙ(OR²)ₚ(NR⁴_{z})₃₋ₙ₋ₚSi-SiR³ₘ(NR⁵_{z})_{q}(OR⁶)_{3-m-q} where R¹ and R³ are independently H or C₁ to C₄ linear or branched, saturated, singly or multiply unsaturated, cyclic, partially or fully fluorinated hydrocarbon; R² and R⁶ are independently C₁ to C₆ linear or branched, saturated, singly or multiply unsaturated, cyclic, aromatic, partially or fully fluorinated hydrocarbon; R⁴ and R⁵ are independently H, C₁ to C₆ linear or branched, saturated, singly or multiply unsaturated, cyclic, aromatic, partially or fully fluorinated hydrocarbon; z is 1 or 2; n is 0 to 3; m is 0 to 3; q is 0 to 3; and p is 0 to 3, provided that n+p ≤ 3 and m+q ≤ 3;
(n) the formula R¹ₙ(OR²)ₚ(NR⁴_{z})₃₋ₙ₋ₚSi-R⁷-SiR³ₘ(NR⁵_{z})_{q}(OR⁶)_{3-m-q} where R¹ and R³ are independently H or C₁ to C₄ linear or branched, saturated, singly or multiply unsaturated, cyclic, partially or fully fluorinated hydrocarbon; R², R⁶ and R⁷ are independently C₁ to C₆ linear or branched, saturated, singly or multiply unsaturated, cyclic, aromatic, partially or fully fluorinated hydrocarbon, alternatively, R⁷ is an amine or an organoamine group; R⁴ and R⁵ are independently H, C₁ to C₆ linear or branched, saturated, singly or multiply unsaturated, cyclic, aromatic, partially or fully fluorinated hydrocarbon; z is 1 or 2; n is 0 to 3; m is 0 to 3; q is 0 to 3; and p is 0 to 3, provided that n+p ≤ 3, and m+q ≤ 3;
(o) the formula (R¹ₙ(OR²)ₚ(NR³_{z})₃-₍ₙ₊ₚ₎Si)ₜCH₄₋ₜ where R¹ is independently H or C₁ to C₄ linear or branched, saturated, singly or multiply unsaturated, cyclic, partially or fully fluorinated hydrocarbon; R² is independently C₁ to C₆ linear or branched, saturated, singly or multiply unsaturated, cyclic, aromatic, partially or fully fluorinated hydrocarbon; R³ is independently H, C₁ to C₆ linear or branched, saturated, singly or multiply unsaturated, cyclic, aromatic, partially or fully fluorinated hydrocarbon; z is 1 or 2; n is 0 to 3; p is 0 to 3; and t is 1 to 4, provided that n+p ≤ 3; and
(p) the formula (R¹ₙ(OR²)ₚ(NR³_{z})₃₋₍ₙ₊ₚ₎Si)ₜNH₃₋ₜ where R¹ is independently H or C₁ to C₄ linear or branched, saturated, singly or multiply unsaturated, cyclic, partially or fully fluorinated hydrocarbon; R² is independently C₁ to C₆ linear or branched, saturated, singly or multiply unsaturated, cyclic, aromatic, partially or fully fluorinated hydrocarbon; R³ is independently H, C₁ to C₆ linear or branched, saturated, singly or multiply unsaturated, cyclic, aromatic, partially or fully fluorinated hydrocarbon; z is 1 or 2; n is 0 to 3; p is 0 to 3; and t is 1 to 3, provided that n+p ≤ 3.

In the above embodiment, the at least one precursor is more preferably at least one selected from: diethoxymethylsilane, dimethyldimethoxysilane, dimethyldiacetoxysilane, methylacetoxy-t-butoxysilane, 1,3-dimethyl-1,3-diethoxydisiloxane, 1,3-dimethyl-1,3-diacetoxydisiloxane, 1,3-dimethyl-1-acetoxy-3-ethoxydisiloxane, 1,3-dimethyl-1,3-diacetoxy-1,3-diethoxydisiloxane, 1,2-dimethyl-1,1,2,2-tetraethoxydisilane, 1,2-dimethyl-1,1,2,2-tetraacetoxydisilane, 1,2-dimethyl-1-acetoxy-2-ethoxydisilane, 1,2-dimethyl-1,2-diacetoxy-1,2-diethoxydisilane, 1,3,5,7-tetramethylcyclotetrasiloxane, and octamethylcyclotetrasiloxane.

The hydrocarbon is preferably selected from: cyclohexane, trimethylcyclohexane, 1-methyl-4(1-methylethyl)cyclohexane, cyclooctane, methylcyclooctane, cyclooctene, cyclooctadiene, cycloheptene, cyclopentene, 1,5,9-cyclododecatriene, ethylene, propylene, acetylene, neohexane, cyclohexene, vinylcyclohexane, dimethylcyclohexene, t-butylcyclohexene, alpha-terpinene, pinene, 1,5-dimethyl-1,5-cyclooctadiene, vinyl-cyclohexene, norbornane, spiro-nonane, decahydronaphthalene, camphene, norbornene, norbornadiene, and adamantane.

In another embodiment, the hydrocarbon and the at least one precursor are the same molecule.

In this embodiment, the at least one precursor is preferably at least one selected from:
a) cyclic siloxanes of the formula (OSiR¹R³)x, where R¹ and R³are independently H, C₁ to C₁₂, linear or branched, saturated, singly or multiply unsaturated, cyclic, partially or fully fluorinated hydrocarbon; and x is an integer from 2 to 8;
b) R¹ₙ(OR²)ₚ(NR³_{z})₄₋₍ₙ₊ₚ₎Si where R¹ is independently H, C₁ to C₁₂, linear or branched, saturated, singly or multiply unsaturated, cyclic, partially or fully fluorinated hydrocarbon; R² is independently C₁ to C₁₂, linear or branched, saturated, singly or multiply unsaturated, cyclic, aromatic, partially or fully fluorinated hydrocarbon; R³ is independently H, C₁ to C₁₂, linear or branched, saturated, singly or multiply unsaturated, cyclic, aromatic, partially or fully fluorinated hydrocarbon; z is 1 or 2; n is 0 to 4; p is 0 to 4; and n+p ≤ 4;
c) R¹ₙ(OR²)p(NR⁴_{z})₃₋ₙ₋pSi-O-SiR³ₘ(NR⁵_{z})_{q}(OR⁶)_{3-m-q} where R¹ and R³ are independently H, C₁ to C₁₂, linear or branched, saturated, singly or multiply unsaturated, cyclic, partially or fully fluorinated hydrocarbon; R² and R⁶ are independently C₁ to C₁₂, linear or branched, saturated, singly or multiply unsaturated, cyclic, aromatic, partially or fully fluorinated hydrocarbon; R⁴ and R⁵ are independently H, C₁ to C₁₂, linear or branched, saturated, singly or multiply unsaturated, cyclic, aromatic, partially or fully fluorinated hydrocarbon; z is 1 or 2; n is 0 to 3; m is 0 to 3; p is 0 to 3; q is 0 to 3; n+p ≤ 3; and m+q ≤ 3;
d) R¹ₙ(OR²)ₚ(NR⁴_{z})₃₋ₙ₋ₚSi-SiR³ₘ(NR⁵_{z})_{q}(OR⁶)_{3-m-q} where R¹ and R³ are independently H, C₁ to C₁₂, linear or branched, saturated, singly or multiply unsaturated, cyclic, partially or fully fluorinated; R² and R⁶ are independently C₁ to C₁₂, linear or branched, saturated, singly or multiply unsaturated, cyclic, aromatic, partially or fully fluorinated; R⁴ and R⁵ are independently H, C₁ to C₁₂, linear or branched, saturated, singly or multiply unsaturated, cyclic, aromatic, partially or fully fluorinated; z is 1 or 2; n is 0 to 3; m is 0 to 3; p is 0 to 3; q is 0 to 3; n+p ≤ 3; and m+q ≤ 3
e) cyclic siloxanes of the formula (OSi(R¹)ₐ(OR²)_{b}(NR³_{z})_{c})ₓ, where R¹, R² and R³ are independently H, C₁ to C₁₂, linear or branched, saturated, singly or multiply unsaturated, cyclic, partially or fully fluorinated; z is 1 or 2; a, b, and c are from 0 to 2 and a+b+c = 2; and x is an integer from 2 to 8;
f) R¹ₙ(OR²)ₚ(O(O)CR³)₄₋₍ₙ₊ₚ₎Si where R¹ is independently H or C₁ to C₁₂ linear or branched, saturated, singly or multiply unsaturated, cyclic, partially or fully fluorinated hydrocarbon; R² and R³ are independently C₁ to C₁₂ linear or branched, saturated, singly or multiply unsaturated, cyclic, aromatic, partially or fully fluorinated hydrocarbon; n is 0 to 4; p is 0 to 4; and n+p ≤ 4 provided that at least one of R¹ is substituted with a C₃ or larger hydrocarbon;
g) R¹ₙ(OR²)ₚ(O(O)CR⁴)₃₋ₙ₋ₚSi-O-SiR³ₘ(O(O)CR⁵)_{q}(OR⁶)_{3-m-q} where R¹ and R³ are independently H or C₁ to C₁₂ linear or branched, saturated, singly or multiply unsaturated, cyclic, partially or fully fluorinated hydrocarbon; R², R⁴, R⁵ and R⁶ are independently C₁ to C₁₂ linear or branched, saturated, singly or multiply unsaturated, cyclic, aromatic, partially or fully fluorinated hydrocarbon; n is 0 to 3; m is 0 to 3; q is 0 to 3; and p is 0 to 3, provided that n+p ≤ 3, m+q ≤ 3, and at least one of R¹ and R³ is substituted with a C₃ or larger hydrocarbon;
h) R¹ₙ(OR²)ₚ(O(O)CR⁴)₃₋ₙ₋ₚSi-SiR³ₘ(O(O)CR⁵)_{q}(OR⁶)_{3-m-q} where R¹ and R³ are independently H or C₁ to C₁₂ linear or branched, saturated, singly or multiply unsaturated, cyclic, partially or fully fluorinated hydrocarbon; R², R⁴, R⁵ and R⁶ are independently C₁ to C₁₂ linear or branched, saturated, singly or multiply unsaturated, cyclic, aromatic, partially or fully fluorinated hydrocarbon; n is 0 to 3; m is 0 to 3; q is 0 to 3; and p is 0 to 3, provided that n+p ≤ 3, m+q ≤ 3, and at least one of R¹ and R³ is substituted with a C₃ or larger hydrocarbon;
i) R¹ₙ(OR²)ₚ(O(O)CR⁴)₃₋ₙ₋ₚSi-R⁷-SiR³ₘ(O(O)CR⁵)_{q}(OR⁶)_{3-m-q} where R¹ and R³ are independently H or C₁ to C₁₂ linear or branched, saturated, singly or multiply unsaturated, cyclic, partially or fully fluorinated hydrocarbon; R², R⁴, R⁵, R⁶, and R⁷ are independently C₁ to C₁₂ linear or branched, saturated, singly or multiply unsaturated, cyclic, aromatic, partially or fully fluorinated hydrocarbon, alternatively, R⁷ is an amine or an organoamine group; n is 0 to 3; m is 0 to 3; q is 0 to 3; and p is 0 to 3, provided that n+p ≤ 3, m+q ≤ 3, and at least one of R¹, R³ and R⁷ is substituted with a C₃ or larger hydrocarbon;
j) (R¹ₙ(OR²)ₚ(O(O)CR³)₃₋₍ₙ₊ₚ₎Si)ₜCH₄₋ₜ where R¹ is independently H or C₁ to C₁₂ linear or branched, saturated, singly or multiply unsaturated, cyclic, partially or fully fluorinated hydrocarbon; R² and R³ are independently C₁ to C₁₂ linear or branched, saturated, singly or multiply unsaturated, cyclic, aromatic, partially or fully fluorinated hydrocarbon; n is 0 to 3; p is 0 to 3; and t is 1 to 4, provided that n+p ≤ 3 and at least one of R¹ is substituted with a C₃ or larger hydrocarbon;
k) (R¹ₙ(OR²)ₚ(O(O)CR³)₃₋₍ₙ₊ₚ₎Si)ₜNH₃₋ₜ where R¹ is independently H or C₁ to C₁₂ linear or branched, saturated, singly or multiply unsaturated, cyclic, partially or fully fluorinated hydrocarbon; R² and R³ are independently C₁ to C₁₂ linear or branched, saturated, singly or multiply unsaturated, cyclic, aromatic, partially or fully fluorinated hydrocarbon; n is 0 to 3; p is 0 to 3; and t is 1 to 3, provided that n+p ≤ 3 and at least one of R¹ is substituted with a C₃ or larger hydrocarbon;
l) cyclic siloxanes of the formula (OSiR¹R³)ₓ, where R¹ and R³ are independently H or C₁ to C₁₂ linear or branched, saturated, singly or multiply unsaturated, cyclic, partially or fully fluorinated hydrocarbon; and x is any integer from 2 to 8, provided that at least one of R¹ and R³ is substituted with a C₃ or larger hydrocarbon;
m) cyclic silazanes of the formula (NR¹SiR¹R³)ₓ, where R¹ and R³ are independently H or C₁ to C₁₂ linear or branched, saturated, singly or multiply unsaturated, cyclic, partially or fully fluorinated hydrocarbon; and x is any integer from 2 to 8, provided that at least one of R¹ and R³ is substituted with a C₃ or larger hydrocarbon;
n) cyclic carbosilanes of the formula (CR¹R³SiR¹R³)ₓ, where R¹ and R³ are independently H or C₁ to C₁₂ linear or branched, saturated, singly or multiply unsaturated, cyclic, partially or fully fluorinated hydrocarbon; and x is any integer from 2 to 8, provided that at least one of R¹ and R³ is substituted with a C₃ or larger hydrocarbon;
o) the formula R¹ₙ(OR²)ₚ(NR³_{z})₄₋₍ₙ₊ₚ₎Si where R¹ is independently H or C₁ to C₁₂ linear or branched, saturated, singly or multiply unsaturated, cyclic, partially or fully fluorinated hydrocarbon; R² and R³ are independently C₁ to C₁₂ linear or branched, saturated, singly or multiply unsaturated, cyclic, aromatic, partially or fully fluorinated hydrocarbon; z is 1 or 2; n is 0 to 4; p is 0 to 4; n+p ≤ 4; and provided that at least one of R¹ is substituted with a C₃ or larger hydrocarbon;
p) the formula R¹ₙ(OR²)ₚ(NH_{y}R⁴_{z})₃₋ₙ₋ₚSi-O-SiR³ₘ(NH_{y}R⁵_{z})_{q}(OR⁶)_{3-m-q} where R¹ and R³ are independently H or C₁ to C₁₂ linear or branched, saturated, singly or multiply unsaturated, cyclic, partially or fully fluorinated hydrocarbon; R², R⁴, R⁵ and R⁶ are independently C₁ to C₁₂ linear or branched, saturated, singly or multiply unsaturated, cyclic, aromatic, partially or fully fluorinated hydrocarbon; y is 0 or 1; z is 1 or 2; y+z = 1 or 2; n is 0 to 3; m is 0 to 3; q is 0 to 3; and p is 0 to 3, provided that n+p ≤ 3, m+q ≤ 3, and at least one of R¹ and R³ is substituted with a C₃ or larger hydrocarbon;
q) the formula R¹ₙ(OR²)ₚ(NH_{y}R⁴_{z})₃₋ₙ₋ₚSi-SiR³ₘ(NH_{y}R⁵_{z})_{q}(OR⁶)_{3-m-q} where R¹ and R³ are independently H or C₁ to C₁₂ linear or branched, saturated, singly or multiply unsaturated, cyclic, partially or fully fluorinated hydrocarbon; R², R⁴, R⁵ and R⁶ are independently C₁ to C₁₂ linear or branched, saturated, singly or multiply unsaturated, cyclic, aromatic, partially or fully fluorinated hydrocarbon; y is 0 or 1; z is 1 or 2; y+z = 1 or 2; n is 0 to 3; m is 0 to 3; q is 0 to 3; and p is 0 to 3, provided that n+p ≤ 3, m+q ≤ 3, and at least one of R¹ and R³ is substituted with a C₃ or larger hydrocarbon;
r) the formula R¹ₙ(OR²)ₚ(NH_{y}R⁴_{z})₃₋ₙ₋ₚSi-R⁷-SiR³ₘ(NH_{y}R⁵_{z})_{q}(OR⁶)_{3-m-q} where R¹ and R³ are independently H or C₁ to C₁₂ linear or branched, saturated, singly or multiply unsaturated, cyclic, partially or fully fluorinated hydrocarbon; R², R⁴, R⁵, R⁶, and R⁷ are independently C₁ to C₁₂ linear or branched, saturated, singly or multiply unsaturated, cyclic, aromatic, partially or fully fluorinated hydrocarbon, alternatively, R⁷ is an amine or an organoamine group; y is 0 or 1; z is 1 or 2; y+z = 1 or 2; n is 0 to 3; m is 0 to 3; q is 0 to 3; and p is 0 to 3, provided that n+p ≤ 3, m+q ≤ 3, and at least one of R¹, R³ and R⁷ is substituted with a C₃ or larger hydrocarbon;
s) the formula (R¹ₙ(OR²)ₚ(NH_{y}R³_{z})₃₋₍ₙ₊ₚ)Si)ₜCH₄₋ₜ where R¹ is independently H or C₁ to C₁₂ linear or branched, saturated, singly or multiply unsaturated, cyclic, partially or fully fluorinated hydrocarbon; R² and R³ are independently C₁ to C₁₂ linear or branched, saturated, singly or multiply unsaturated, cyclic, aromatic, partially or fully fluorinated hydrocarbon; y is 0 or 1; z is 1 or 2; y+z = 1 or 2; n is 0 to 3; p is 0 to 3, and t is 1 to 4, provided that n+p ≤ 3 and at least one of R¹ is substituted with a C₃ or larger hydrocarbon;
t) the formula (R¹ₙ(OR²)ₚ(NH_{y}R³_{z})₃₋₍ₙ₊ₚ₎Si)ₜNH₃₋ₜ where R¹ is independently H or C₁ to C₁₂ linear or branched, saturated, singly or multiply unsaturated, cyclic, partially or fully fluorinated hydrocarbon; R² and R³ are independently C₁ to C₁₂ linear or branched, saturated, singly or multiply unsaturated, cyclic, aromatic, partially or fully fluorinated hydrocarbon; y is 0 or 1; z is 1 or 2; y+z = 1 or 2; n is 0 to 3; p is 0 to 3; and t is 1 to 3, provided that n+p ≤ 3 and at least one of R¹ is substituted with a C₃ or larger hydrocarbon;
u) cyclic siloxanes of the formula (OSi(R¹)ₐ(OR²)_{b}NR³_{z})_{c})ₓ, where R¹, R² and R³ are independently H or C₁ to C₁₂ linear or branched, saturated, singly or multiply unsaturated, cyclic, partially or fully fluorinated hydrocarbon; x is an integer from 2 to 8; z is 1 or 2; a, b, and c are from 0 to 2; and a+b+c = 2, provided that at least one of R¹, R², and R³ is substituted with a C₃ or larger hydrocarbon;
v) cyclic silazanes of the formula (NR¹Si(R¹)ₐ(OR²)_{b}NR³_{z})_{c})ₓ, where R¹, R², and R³ are independently H or C₁ to C₁₂ linear or branched, saturated, singly or multiply unsaturated, cyclic, partially or fully fluorinated hydrocarbon; x is an integer from 2 to 8; z is 1 or 2; a, b, and c are from 0 to 2; and a+b+c = 2, provided that at least one of R¹ and R³ is substituted with a C₃ or larger hydrocarbon; and
w) cyclic carbosilanes of the formula (CR¹R³Si(OR²)_{b}NR³_{z})_{c})ₓ, where R¹, R², and R³ are independently H or C₁ to C₁₂ linear or branched, saturated, singly or multiply unsaturated, cyclic, partially or fully fluorinated hydrocarbon; x is an integer from 2 to 8; z is 1 or 2; b and c are from 0 to 2; and b+c = 2, provided that at least one of R¹, R² and R³ is substituted with a C₃ or larger hydrocarbon.

More preferably, the at least one precursor is at least one selected from: 1-neohexyl-1,3,5,7-tetramethylcyclotetrasiloxane, dimethylamino-t-butoxy-neo-hexylsilane, diethoxy-neo-hexylsilane, 1,3-diethylamino-1,3-di-t-butoxy-1-neohexyldisiloxane, 1,3-diethoxy-1,3-diphenyldisiloxane, 1,2-dipropylamino-1,2-di-t-butoxy-1-neohexyldisilane, 1,2-diethoxy-1-neo-hexyldisilane, and 1,4-bis(dimethoxysilyl)cyclohexane.

### BRIEF DESCRIPTION OF SEVERAL VIEWS OF THE DRAWINGS

FIGS. 1A-1 D illustrate cross-sections that reflect structures that may result after certain steps are used to make a semiconductor device according to one embodiment of the present invention;
FIG. 2 is a graph illustrating the light absorbance of one embodiment of an antireflective coating according to the present invention;
FIG. 3 depicts a series of FTIR spectra for antireflective coatings according to the present invention;
FIG. 4 is a graph illustrating the light absorbance of antireflective coatings according to the present invention;
FIG. 5 is a graph illustrating the light absorbance of antireflective coatings according to the present invention versus rf power; and
FIG. 6 compares FTIR spectra of an antireflective coating according to the present invention before and after exposure to UV light.

### DETAILED DESCRIPTION OF THE INVENTION

A method of forming a semiconductor device is described. In one embodiment of the present invention, the method comprises the following steps. First, a dielectric layer is formed on a substrate and an antireflective coating is formed over the dielectric layer. Next, a photoresist pattern is formed over the antireflective coating and the dielectric layer is etched through the patterned photoresist. The antireflective coating and the photoresist are then removed. The antireflective coating according to the present invention is preferably a film represented by the formula SiᵥO_{w}CₓNᵤH_{y}F_{z}, wherein v+w+x+u+y+z = 100%, v is from 10 to 35 atomic%, w is from 5 to 65 atomic%, x is from 5 to 80 atomic%, u is from 0 to 50 atomic %, y is from 10 to 50 atomic% and z is from 0 to 15 atomic%. The antireflective coating according to the present invention is formed by the chemical vapor deposition of a composition comprising (1) at least one precursor selected from an organosilane, an organosiloxane, and an aminosilane; and (2) a hydrocarbon; and preferably wherein the hydrocarbon is not removed from the antireflective coating.

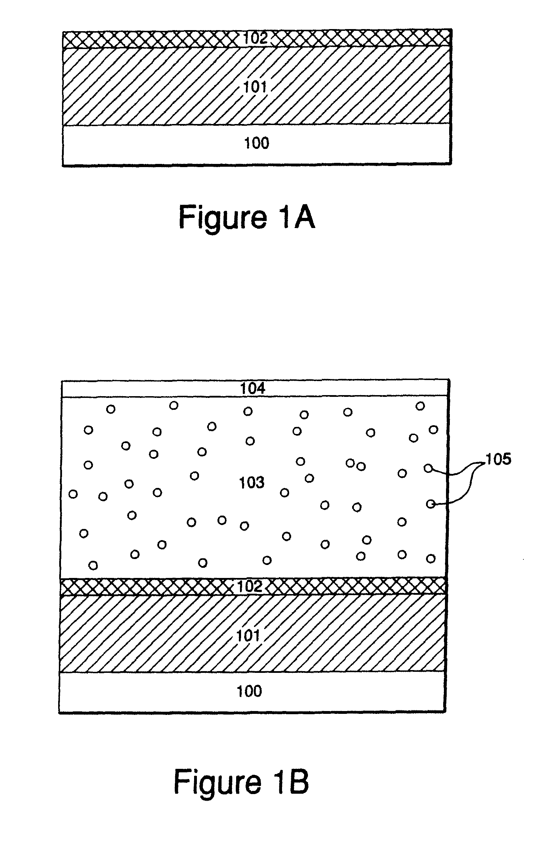

FIGS. 1A-1 D illustrate a preferred embodiment of the method of the present invention. In that embodiment, first conductive layer 101 is optionally formed on substrate 100. Substrate 100 may be any surface, generated when making an integrated circuit, upon which a conductive layer may be formed. Substrate 100 thus may include, for example, active and passive devices that are formed on a silicon wafer such as transistors, capacitors, resistors, diffused junctions, gate electrodes, local interconnects, etc. Substrate 100 also may include insulating materials that separate such active and passive devices from the conductive layer or layers that are formed on top of them, and may include previously formed conductive layers.

Suitable materials that may be included in substrate 100 include, but are not limited to, semiconductor materials such as gallium arsenide ("GaAs"), silicon, and compositions containing silicon such as crystalline silicon, polysilicon, amorphous silicon, epitaxial silicon, silicon dioxide ("SiO₂"), silicon glass, silicon nitride, fused silica, glass, quartz, borosilicate glass, and combinations thereof. Other suitable materials include chromium, molybdenum, and other metals commonly employed in semiconductor, integrated circuits, flat panel display, and flexible display applications. Substrate 100 may have additional layers such as, for example, silicon, SiO₂, organosilicate glass (OSG), fluorinated silicate glass (FSG), boron carbonitride, silicon carbide, hydrogenated silicon carbide, silicon nitride, hydrogenated silicon nitride, silicon carbonitride, hydrogenated silicon carbonitride, boronitride, organic-inorganic composite materials, photoresists, organic polymers, porous organic and inorganic materials and composites, metal oxides such as aluminum oxide, and germanium oxide. Still further layers can also be germanosilicates, aluminosilicates, copper and aluminum, and diffusion barrier materials such as, but not limited to, TiN, Ti(C)N, TaN, Ta(C)N, Ta, W, or WN.

Conductive layer 101 may be made from materials conventionally used to form conductive layers for semiconductor devices. In a preferred embodiment, conductive layer 101 includes copper, and is formed using a conventional copper electroplating process. Although copper is preferred, other conducting materials, which may be used to make a semiconductor device, may be used instead. Conductive layer 101 may be planarized, after it is deposited, using a chemical mechanical polishing ("CMP") step.

After forming conductive layer 101 on substrate 100, barrier layer 102 is typically formed on conductive layer 101. Barrier layer 102 typically serves to prevent an unacceptable amount of copper, or other metal, from diffusing into dielectric layer 103. Barrier layer 102 also acts as an etch stop to prevent subsequent via and trench etch steps from exposing conductive layer 101 to subsequent cleaning steps. Barrier layer 102 preferably is made from a hermetic dielectric material such as, or example, silicon, SiO₂, organosilicate glass (OSG), boron carbonitride, fluorinated silicate glass (FSG), silicon carbide, hydrogenated silicon carbide, silicon nitride, hydrogenated silicon nitride, silicon carbonitride, hydrogenated silicon carbonitride, boronitride, organic-inorganic composite materials, organic and inorganic materials and composites, metal oxides such as aluminum oxide, germanium oxide, and combinations thereof.

A chemical vapor deposition process may be used to form barrier layer 102. Barrier layer 102 should be thick enough to perform its diffusion inhibition and etch stop functions, but not so thick that it adversely impacts the overall dielectric characteristics resulting from the combination of barrier layer 102 and dielectric layer 103. FIG. 1A illustrates a cross-section of the structure that results after conductive layer 101 and barrier layer 102 have been formed on substrate 100.

Referring to Figure 1 B, dielectric layer 103 is then formed on top of barrier layer 102. Preferably dielectric layer 103 is porous as is indicated by the presence of pores 105 and will herein be referred to as "porous dielectric layer 103". In the method of the present invention, porous dielectric layer 103 is formed from the deposition of a film-forming composition comprising a compound or compounds that are capable of forming and maintaining an interconnect network. Examples of the films include, but are not limited to, SiO₂, organosilicate glass (OSG), fluorinated silicate glass (FSG), boron carbonitride, silicon carbide, hydrogenated silicon carbide, silicon nitride, hydrogenated silicon nitride, silicon carbonitride, hydrogenated silicon carbonitride, boronitride, organic-inorganic composite materials, photoresists, organic polymers, porous organic and inorganic materials and composites, metal oxides such as aluminum oxide, and germanium oxide, diamond-like carbon, borosilicate glass (Si:O:B:H), or phosphorous doped borosilicate glass (Si:O:B:H:P), and combinations thereof.

In preferred embodiments of the present invention, porous dielectric layer 103 comprises a silica material. The term "silica", as used herein, is a material that has silicon (Si) and oxygen (O) atoms, and possibly additional substituents such as, but not limited to, other elements such as C, H, B, N, P, or halide atoms; alkyl groups; or aryl groups. In alternative embodiments, porous dielectric layer 103 is may contain, for example, other elements such as, but not limited to, Al, Ti, V, In, Sn, Zn, Ga, and combinations thereof. In certain preferred embodiments, dielectric layer 103 may comprise an OSG compound represented by the formula SiᵥO_{w}CₓH_{y}F_{z}, where v+w+x+y+z = 100 atomic%, v is from 10 to 35 atomic%, w is from 10 to 65 atomic%, x is from 5 to 30 atomic%, y is from 10 to 50 atomic% and z is from 0 to 15 atomic%.

Still referring to Figure 1 B, porous dielectric layer 103 is characterized by the presence of pores 105. In such embodiments, pores 105 are formed when the film-forming composition comprises a silica source and at least one porogen that is capable of being easily, and preferably substantially removed upon exposure to one or more energy sources. A "porogen" is a reagent that is used to generate void volume within the resultant film. Regardless of whether or not the porogen is unchanged throughout the inventive process, the term "porogen" as used herein is intended to encompass pore-forming reagents (or pore-forming substituents) and derivatives thereof, in whatever forms they are found throughout the entire process described herein. Suitable compounds to be used as the porogen include, but are not limited to, hydrocarbon materials, labile organic groups, solvents, decomposable polymers, surfactants, dendrimers, hyper-branched polymers, polyoxyalkylene compounds, compounds comprising C and H, or combinations thereof. In certain embodiments, the porogen comprises a C₁ to C₁₃ hydrocarbon compound.

In forming pores 105, the as-deposited material from which dielectric layer 103 is made is typically exposed to one or more energy sources to cure the film and/or remove at least a portion of the porogen contained therein if present. Exemplary energy sources may include, but are not limited to, an ionizing radiation source such as α-particles, β-particles, γ-rays, x-rays, electron beam sources of energy; a non-ionizing radiation source such as ultraviolet (10 to 400 nm), visible (400 to 750 nm), infrared (750 to 10⁵ nm), microwave (> 10⁶), and radio-frequency (> 10⁶) wavelengths of energy; or compositions thereof. Still further energy sources include thermal energy and plasma energy. Depending upon the energy source, the exposure step can be conducted under high pressure, atmospheric, or under a vacuum. The environment can be inert (e.g., nitrogen, CO₂, noble gases (He, Ar, Ne, Kr, Xe)), oxidizing (e.g., oxygen, air, dilute oxygen environments, enriched oxygen environments, ozone, nitrous oxide) or reducing (dilute or concentrated hydrogen, hydrocarbons (saturated, unsaturated, linear or branched, aromatics)). The temperature for the exposure step may range from 100 to 500°C. In certain embodiments, the temperature may be ramped at a rate is from 0.1 to 100 deg °C/min. The total treatment time is preferably from 0.01 min to 12 hours.

Porous dielectric layer 103 is typically formed as a film onto at least a portion of substrate 100 (which may include conductive layer 101 and/or barrier layer 102) from a film-forming composition using a variety of different methods. These methods may be used by themselves or in combination. Some examples of processes that may be used to form the films include the following: thermal chemical vapor deposition, plasma enhanced chemical vapor deposition ("PECVD"), high density PECVD, photon assisted CVD, plasma-photon assisted ("PPECVD"), atomic layer deposition (ALD), cryogenic chemical vapor deposition, chemical assisted vapor deposition, hot-filament chemical vapor deposition, CVD of a liquid polymer precursor, deposition from supercritical fluids, or transport polymerization ("TP"). U. S. Pat. Nos. 6,171,945, 6,054,206, 6,054,379, 6,159,871 and WO 99/41423 provide some exemplary CVD methods that may be used to form the film. Besides chemical vapor deposition processes, other processes can be used to apply porous dielectric layer 103 such as, for example, non-contact deposition methods. Non-contact deposition methods typically allow films to be formed without the need of contact masks or shutters. Non-contact deposition methods include, for example, dipping, rolling, brushing, spraying, extrusion, spin-on deposition, air-knife, printing, and combinations thereof. Further exemplary deposition methods include oscillating non-contact induced spreading forces, gravity-induced spreading forces, wetting-induced spreading forces, slot extrusion, and combinations thereof.

In one particular embodiment, porous dielectric layer 103 is deposited using a spin-on deposition method. In brief, the film-forming composition is dispensed onto a substrate and the solvent contained therein is evaporated to form the coated substrate. Further, centrifugal force is used to ensure that the composition is uniformly deposited onto the substrate. Another benefit is that the composition efficiently fills any gaps that may be present.

In embodiments where porous dielectric layer 103 is deposited using a spin-on deposition method, the film is typically formed from a composition that comprises, inter *alia,* at least one silica source, optionally a porogen, optionally a catalyst, and water. In certain embodiments, the composition may further optionally comprise a solvent. In brief, dispensing the composition onto a substrate and evaporating the solvent and water can form the film. Any remaining solvent, water, and porogen if present are generally removed by exposing the coated substrate to one or more energy sources and for a time sufficient to produce the low dielectric film. Examples of spin-on deposited materials and films and methods for making same are found in U. S. Published Applications 2004/0048960 and 2003/0224156.

The following silica sources are suitable for use in the present invention in either a spin-on deposition process or a CVD process. As such, at least one of the following silica sources typically form the composition that will be deposited to form porous dielectric layer 103, for example, along with optionally a porogen, optionally a solvent, and optionally water. In the chemical formulas which follow and in all chemical formulas throughout this document, the term "independently" should be understood to denote that the subject R group is not only independently selected relative to other R groups bearing different superscripts, but is also independently selected relative to any additional species of the same R group. For example, in the formula RₐSi(OR¹)₄₋ₐ, when "a" is 2, the two R groups need not be identical to each other or to R¹. In addition, in the following formulas, the term "monovalent organic group" relates to an organic group bonded to an element of interest, such as Si or O, through a single C bond, *i.e.,* Si-C or O-C. Examples of monovalent organic groups include an alkyl group, an aryl group, an unsaturated alkyl group, and/or an unsaturated alkyl group substituted with alkoxy, ester, acid, carbonyl, or alkyl carbonyl functionality. The alkyl group may be a linear, branched, or cyclic alkyl group having from 1 to 5 carbon atoms such as, for example, a methyl, ethyl, propyl, butyl, or pentyl group. Examples of aryl groups suitable as the monovalent organic group include phenyl, methylphenyl, ethylphenyl and fluorophenyl. In certain embodiments, one or more hydrogens within the alkyl group may be substituted with an additional atom such as a halide atom (*i.e.,* fluorine), or an oxygen atom to give a carbonyl or ether functionality.

Other examples of the silica source may include a fluorinated silane or fluorinated siloxane such as those provided in U. S. Pat. No. 6,258,407.

Another example of the silica source may include compounds that produce a Si-H bond upon elimination.

In other embodiments of the present invention, the silica source may preferably have an at least one carboxylic acid ester bonded to the Si atom. Examples of these silica sources include tetraacetoxysilane, methyltriacetoxysilane, ethyltriacetoxysilane, and phenyltriacetoxysilane. In addition to the at least one silica source wherein the silica source has at least one Si atom having a carboxylate group attached thereto, the composition may further comprise additional silica sources that may not necessarily have the carboxylate attached to the Si atom.

The silica source may also be a linear, cyclic, or branched siloxane, a linear, cyclic, or branched carbosiliane, a linear, cyclic, or branched silazane, or mixtures thereof.

In embodiments of the present invention wherein a CVD process is used to deposit, for example, dielectric layer 103, the layer is deposited using gaseous reagents. Although the phrase "gaseous reagents" is sometimes used herein to describe the reagents, the phrase is intended to encompass reagents delivered directly as a gas to the reactor, delivered as a vaporized liquid, a sublimed solid and/or transported by an inert carrier gas into the reactor. In preferred embodiments of the present invention, the material is formed through a PECVD process. In such process, gaseous reagents typically flow into a reaction chamber such as a vacuum chamber and plasma energy energizes the gaseous reagents thereby forming a film on at least a portion of the substrate. In these embodiments, the film can be formed by the co-deposition, or alternatively the sequential deposition, of a gaseous mixture comprising at least one silica-containing precursor gas and at least one plasma-polymerizable organic precursor or porogen gas. In certain embodiments, the plasma energy applied may range from 0.02 to 7 watts/cm², more preferably 0.3 to 3 watts/cm². Flow rates for each of the gaseous reagents may range from 10 to 5000 sccm. Pressure values in the vacuum chamber during deposition for a PECVD process of the present invention may range from 0.01 (1 Pa) to 600 torr (80 kPa), more preferably 1 (100 Pa) to 10 torr (1 kPa). In certain embodiments, the deposition is conducted at a temperature ranging from 100 to 425°C, or from 200 to 425°C, or from 200 to 300°C. It is understood however that process parameters such as plasma energy, flow rate, pressure, and temperature may vary depending upon numerous factors such as the surface area of the substrate, the precursors used, the equipment used in the PECVD process, etc.

In one embodiment of the CVD process wherein porous dielectric layer 103 consists essentially of Si, C, O, H, and F, porous dielectric layer 103 is formed by providing substrate 100 (which may include conductive layer 101 and/or barrier layer 102) within a vacuum chamber; introducing into the vacuum chamber gaseous reagents that comprises at least one silica-containing precursor gas selected from an organosilane and an organosiloxane, optionally a fluorine-providing precursor gas, and at least one porogen; and applying energy to the gaseous reagents in the chamber to induce reaction of the gaseous reagents and to form the film on the substrate.
Examples of suitable porogen precursors and other silicon-containing precursors are found in U. S. Pat. Nos. 6,726,770, 6,583,048, and 6,846,515. Other suitable porogen precursors are found in U.S. patent publication No. 2002/0180051, and U.S. Patent Nos. 6, 441,491 and 6,437,443.

The method of the present invention includes the step of forming an antireflective coating over the dielectric layer. Referring now to FIG. 1 B, antireflective coating 104 is deposited on top of dielectric layer 103. Antireflective coating 104 may be, for example, a bottom antireflective coating (BARC), a hardmask, an etch resistant layer, a photoreisst, a sacrificial capping layer, a chemical barrier, an adhesion layer, or perform any number of the above functions in an integrated circuit device manufacturing process scheme.

According to the present invention, antireflective coating 104 is preferably a film represented by the formula SiᵥO_{w}CₓNᵤH_{y}F_{z}, wherein v+w+x+u+y+z = 100%, v is from 10 to 35 atomic%, w is from 5 to 65 atomic%, x is from 5 to 80 atomic%, u is from 0 to 50 atomic %, y is from 10 to 50 atomic% and z is from 0 to 15 atomic%. Preferably, antireflective coating 104 is formed by the chemical vapor deposition of a composition comprising (1) at least one precursor selected from an organosilane, an organosiloxane, and an aminosilane; and (2) a hydrocarbon. The hydrocarbon functions to provide a species that absorbs light. Whether a species absorbs light at wavelengths less than 400 nm is measured by the ability of the resultant film to minimize light from being reflected such as, for example, back toward a top coat or photoresist, yet be essentially transparent at higher wavelengths such as at 632 nm where alignment processes are performed. Light absorption can be measured by numerous tools, such as spectrophotometers, reflectometers and ellipsometers, and in some cases may be interpreted as the imaginary portion of the refractive index as this is normally related to the absorptive properties of the film.

In some embodiments of the present invention, the hydrocarbon is an organic hydrocarbon and is distinct from the organosilane, the organosiloxane, and the aminosilane. In some embodiments of the present invention, the organic hydrocarbon consists of only carbon and hydrogen atoms.

The following are non-limiting examples of at least one precursor selected from an organosilane, an organosiloxane, and an aminosilane that is suitable for use with a distinct hydrocarbon. In the chemical formulas which follow and in all chemical formulas throughout this document, the term "independently" should be understood to denote that the subject R group is not only independently selected relative to other R groups bearing different superscripts, but is also independently selected relative to any additional species of the same R group. For example, in the formula R¹ₙ(OR²)₄₋ₙSi, when n is 2 or 3, the two or three R¹ groups need not be identical to each other or to R².

Bis(tertiarybutylamino)silanes are non-limiting examples of the at least one precursor that is an aminosilane that is suitable for use with a distinct hydrocarbon. Bis(tertiarybutylamino)silanes have a formula (t-C₄H₉NH)₂Si(H)₂.

The following are formulas representing certain Si-based precursors suitable for use with a distinct light absorber:
(a) the formula R¹ₙ(OR²)ₚ(O(O)CR³)₄₋₍ₙ₊ₚ₎Si, where R¹ is independently H or C₁ to C₄ linear or branched, saturated, singly or multiply unsaturated, cyclic, partially or fully fluorinated hydrocarbon; R² is independently C₁ to C₆ linear or branched, saturated, singly or multiply unsaturated, cyclic, aromatic, partially or fully fluorinated hydrocarbon; R³ is independently H, C₁ to C₆ linear or branched, saturated, singly or multiply unsaturated, cyclic, aromatic, partially or fully fluorinated hydrocarbon; n is 0 to 4; and p is 0 to 4 (Examples: diethoxymethylsilane, dimethyldimethoxysilane, dimethyldiacetoxysilane, methylacetoxy-t-butoxysilane);
(b) the formula R¹ₙ(OR²)ₚ(O(O)CR⁴)₃₋ₙ₋ₚSi-O-SiR³ₘ(O(O)CR⁵)_{q}(OR⁶)_{3-m-q}, where R¹ and R³ are independently H or C₁ to C₄ linear or branched, saturated, singly or multiply unsaturated, cyclic, partially or fully fluorinated hydrocarbon; R² and R⁶ are independently C₁ to C₆ linear or branched, saturated, singly or multiply unsaturated, cyclic, aromatic, partially or fully fluorinated hydrocarbon; R⁴ and R⁵ are independently H, C₁ to C₆ linear or branched, saturated, singly or multiply unsaturated, cyclic, aromatic, partially or fully fluorinated hydrocarbon; n is 0 to 3; m is 0 to 3; q is 0 to 3; and p is 0 to 3, provided that n+p ≤ 3 and m+q ≤ 3 (Examples: 1,3-dimethyl-1,3-diethoxydisiloxane, 1,3-dimethyl-1,3-diacetoxydisiloxane, 1,3-dimethyl-1-acetoxy-3-ethoxydisiloxane, 1,3-dimethyl-1,3-diacetoxy-1,3-diethoxydisiloxane);
(c) the formula R¹ₙ(OR²)ₚ(O(O)CR⁴)₃₋ₙ₋ₚSi-SiR³ₘ(O(O)CR⁵)_{q}(OR⁶)_{3-m-q} where R¹ and R³ are independently H or C₁ to C₄ linear or branched, saturated, singly or multiply unsaturated, cyclic, partially or fully fluorinated hydrocarbon; R² and R⁶ are independently C₁ to C₆ linear or branched, saturated, singly or multiply unsaturated, cyclic, aromatic, partially or fully fluorinated hydrocarbon; R⁴ and R⁵ are independently H, C₁ to C₆ linear or branched, saturated, singly or multiply unsaturated, cyclic, aromatic, partially or fully fluorinated hydrocarbon; n is 0 to 3; m is 0 to 3; q is 0 to 3; and p is 0 to 3, provided that n+p ≤ 3 and m+q ≤ 3 (Examples: 1,2-dimethyl-1,1,2,2-tetraethoxydisilane, 1,2-dimethyl-1,1,2,2-tetraacetoxydisilane, 1,2-dimethyl-1-acetoxy-2-ethoxydisilane, 1,2-dimethyl-1,2-diacetoxy-1,2-diethoxydisilane);
(d) the formula R¹ₙ(OR²)ₚ(O(O)CR⁴)₃₋ₙ₋ₚSi-R⁷-SiR³ₘ(O(O)CR⁵)_{q}(OR⁶)_{3-m-q} where R¹ and R³ are independently H or C₁ to C₄ linear or branched, saturated, singly or multiply unsaturated, cyclic, partially or fully fluorinated hydrocarbon; R², R⁶ and R⁷ are independently C₁ to C₆ linear or branched, saturated, singly or multiply unsaturated, cyclic, aromatic, partially or fully fluorinated hydrocarbon, alternatively, R⁷ is an amine or an organoamine group; R⁴ and R⁵ are independently H, C₁ to C₆ linear or branched, saturated, singly or multiply unsaturated, cyclic, aromatic, partially or fully fluorinated hydrocarbon; n is 0 to 3; m is 0 to 3; q is 0 to 3; and p is 0 to 3, provided that n+p ≤ 3, and m+q ≤ 3;
(e) the formula (R¹ₙ(OR²)ₚ(O(O)CR³)₃₋₍ₙ₊ₚ₎Si)ₜCH₄₋ₜ where R¹ is independently H or C₁ to C₄ linear or branched, saturated, singly or multiply unsaturated, cyclic, partially or fully fluorinated hydrocarbon; R² is independently C₁ to C₆ linear or branched, saturated, singly or multiply unsaturated, cyclic, aromatic, partially or fully fluorinated hydrocarbon; R³ is independently H, C₁ to C₆ linear or branched, saturated, singly or multiply unsaturated, cyclic, aromatic, partially or fully fluorinated hydrocarbon; n is 0 to 3; p is 0 to 3; and t is 2 to 4, provided that n+p ≤ 4;
(f) the formula (R¹ₙ(OR²)ₚ(O(O)CR³)₃₋₍ₙ₊ₚ₎Si)ₜNH₃₋ₜ where R¹ is independently H or C₁ to C₄ linear or branched, saturated, singly or multiply unsaturated, cyclic, partially or fully fluorinated hydrocarbon; R² is independently C₁ to C₆ linear or branched, saturated, singly or multiply unsaturated, cyclic, aromatic, partially or fully fluorinated hydrocarbon; R³ is independently H, C₁ to C₆ linear or branched, saturated, singly or multiply unsaturated, cyclic, aromatic, partially or fully fluorinated hydrocarbon; n is 0 to 3; p is 0 to 3; and t is 1 to 3, provided that n+p ≤ 4;
(g) cyclic siloxanes of the formula (OSiR₁R₃)ₓ, where R¹ and R³ are independently H, C₁ to C₄, linear or branched, saturated, singly or multiply unsaturated, cyclic, partially or fully fluorinated; and x is an integer from 2 to 8 (Examples: 1,3,5,7-tetramethylcyclotetrasiloxane, octamethylcyclotetrasiloxane);
(h) cyclic silazanes of the formula (NR₁SiR₁R₃)ₓ, where R¹ and R³ are independently H, C₁ to C₄, linear or branched, saturated, singly or multiply unsaturated, cyclic, partially or fully fluorinated; and x is an integer from 2 to 8;
(i) cyclic carbosilanes of the formula (CR₁R₃SiR₁R₃)ₓ, where R¹ and R³are independently H, C₁ to C₄, linear or branched, saturated, singly or multiply unsaturated, cyclic, partially or fully fluorinated; and x is an integer from 2 to 8;
(k) the formula R¹ₙ(OR²)ₚ(NR³)₄₋₍ₙ₊ₚ₎Si where R¹ is independently H or C₁ to C₄ linear or branched, saturated, singly or multiply unsaturated, cyclic, partially or fully fluorinated hydrocarbon; R² is independently C₁ to C₆ linear or branched, saturated, singly or multiply unsaturated, cyclic, aromatic, partially or fully fluorinated hydrocarbon; R³ is independently H, C₁ to C₆ linear or branched, saturated, singly or multiply unsaturated, cyclic, aromatic, partially or fully fluorinated hydrocarbon; n is 0 to 3; and p is 0 to 3;
(l) the formula R¹ₙ(OR²)ₚ(NR⁴)₃₋ₙ₋ₚSi-O-SiR³ₘ(NR⁵)_{q}(OR⁶)_{3-m-q} where R¹ and R³ are independently H or C₁ to C₄ linear or branched, saturated, singly or multiply unsaturated, cyclic, partially or fully fluorinated hydrocarbon; R² and R⁶ are independently C₁ to C₆ linear or branched, saturated, singly or multiply unsaturated, cyclic, aromatic, partially or fully fluorinated hydrocarbon; R⁴ and R⁵ are independently H, C₁ to C₆ linear or branched, saturated, singly or multiply unsaturated, cyclic, aromatic, partially or fully fluorinated hydrocarbon; n is 0 to 3; m is 0 to 3; q is 0 to 3; and p is 0 to 3, provided that n+p ≤ 3 and m+q ≤ 3;
(m) the formula R¹ₙ(OR²)ₚ(NR⁴)₃₋ₙ₋ₚSi-SiR³ₘ(NR⁵)_{q}(OR⁶)_{3-m-q} where R¹ and R³ are independently H or C₁ to C₄ linear or branched, saturated, singly or multiply unsaturated, cyclic, partially or fully fluorinated hydrocarbon; R² and R⁶ are independently C₁ to C₆ linear or branched, saturated, singly or multiply unsaturated, cyclic, aromatic, partially or fully fluorinated hydrocarbon; R⁴ and R⁵ are independently H, C₁ to C₆ linear or branched, saturated, singly or multiply unsaturated, cyclic, aromatic, partially or fully fluorinated hydrocarbon; n is 0 to 3; m is 0 to 3; q is 0 to 3; and p is 0 to 3, provided that n+p ≤ 3 and m+q ≤ 3;
(n) the formula R¹ₙ(OR²)ₚ(NR⁴)₃₋ₙ₋ₚSi-R⁷-SiR³ₘ(NR⁵)_{q}(OR⁶)_{3-m-q} where R¹ and R³ are independently H or C₁ to C₄ linear or branched, saturated, singly or multiply unsaturated, cyclic, partially or fully fluorinated hydrocarbon; R², R⁶ and R⁷ are independently C₁ to C₆ linear or branched, saturated, singly or multiply unsaturated, cyclic, aromatic, partially or fully fluorinated hydrocarbon, alternatively, R⁷ is an amine or an organoamine group; R⁴ and R⁵ are independently H, C₁ to C₆ linear or branched, saturated, singly or multiply unsaturated, cyclic, aromatic, partially or fully fluorinated hydrocarbon; n is 0 to 3; m is 0 to 3; q is 0 to 3; and p is 0 to 3, provided that n+p ≤ 3, and m+q ≤ 3;
(o) the formula (R¹ₙ(OR²)ₚ(NR³)₃₋₍ₙ₊ₚ₎Si)ₜCH₄₋ₜ where R¹ is independently H or C₁ to C₄ linear or branched, saturated, singly or multiply unsaturated, cyclic, partially or fully fluorinated hydrocarbon; R² is independently C₁ to C₆ linear or branched, saturated, singly or multiply unsaturated, cyclic, aromatic, partially or fully fluorinated hydrocarbon; R³ is independently H, C₁ to C₆ linear or branched, saturated, singly or multiply unsaturated, cyclic, aromatic, partially or fully fluorinated hydrocarbon; n is 0 to 3; p is 0 to 3; and t is 1 to 4, provided that n+p ≤ 4;
(p) the formula (R¹ₙ(OR²)ₚ(NR³)₃₋₍ₙ₊ₚ₎Si)ₜNH₃₋ₜ where R¹ is independently H or C₁ to C₄ linear or branched, saturated, singly or multiply unsaturated, cyclic, partially or fully fluorinated hydrocarbon; R² is independently C₁ to C₆ linear or branched, saturated, singly or multiply unsaturated, cyclic, aromatic, partially or fully fluorinated hydrocarbon; R³ is independently H, C₁ to C₆ linear or branched, saturated, singly or multiply unsaturated, cyclic, aromatic, partially or fully fluorinated hydrocarbon; n is 0 to 3; p is 0 to 3; and t is 1 to 3, provided that n+p ≤ 4.

The above precursors may be mixed with light absorber or have attached light absorbing substituents, and may be mixed with other molecules of these classes and/or with molecules of the same classes. Examples: TEOS, triethoxysilane, ditertiarybutoxysilane, silane, disilane, di-tertiarybutoxydiacetoxysilane.

The following are non-limiting examples of hydrocarbons that are suitable for use in embodiments of the present invention wherein the hydrocarbon is distinct from the at least one precursor selected from an organosilane and an organosiloxane. In other words, the following compounds are suitable for use as light absorbers according to the invention:
1) Cyclic hydrocarbons of the general formula CₙH₂ₙ where n = 4 - 14, where the number of carbons in the cyclic structure is between 4 and 12, and where there can be a plurality of simple or branched hydrocarbons substituted onto the cyclic structure. Examples include: cyclohexane, trimethylcyclohexane, 1-methyl-4(1-methylethyl)cyclohexane, cyclooctane, methylcyclooctane, cyclooctene, cyclooctadiene, cycloheptene, cyclopentene, cyclohexene, and 1,5,9-cyclododecatriene.
2) Linear or branched, saturated, singly or multiply unsaturated hydrocarbons of the general formula CₙH_{(2n+2)-2y} where n = 2 - 20 and where y = 0 - n. Examples include: ethylene, propylene, acetylene, neohexane.
3) Singly or multiply unsaturated cyclic hydrocarbons of the general formula CₙH₂ₙ₋₂ₓ where x is the number of unsaturated sites in the molecule, n = 4 - 14, where the number of carbons in the cyclic structure is between 4 and 10, and where there can be a plurality of simple or branched hydrocarbons substituted onto the cyclic structure. The unsaturation can be located inside endocyclic or on one of the hydrocarbon substituents to the cyclic structure. Examples include cyclohexene, vinylcyclohexane, dimethylcyclohexene, t-butylcyclohexene, alpha-terpinene, pinene, 1,5-dimethyl-1,5-cyclooctadiene, vinyl-cyclohexene.
4) Bicyclic hydrocarbons of the general formula CₙH₂ₙ₋₂ where n = 4 - 14, where the number of carbons in the bicyclic structure is between 4 and 12, and where there can be a plurality of simple or branched hydrocarbons substituted onto the cyclic structure. Examples include, norbornane, spiro-nonane, decahydronaphthalene.
5) Multiply unsaturated bicyclic hydrocarbons of the general formula CₙH₂ₙ₋₍₂₊₂ₓ₎ where x is the number of unsaturated sites in the molecule, n = 4 - 14, where the number of carbons in the bicyclic structure is between 4 and 12, and where there can be a plurality of simple or branched hydrocarbons substituted onto the cyclic structure. The unsaturation can be located inside endocyclic or on one of the hydrocarbon substituents to the cyclic structure. Examples include camphene, norbornene, norbornadiene.
6) Tricyclic hydrocarbons of the general formula CₙH₂ₙ₋₄ where n = 4 - 14, where the number of carbons in the tricyclic structure is between 4 and 12, and where there can be a plurality of simple or branched hydrocarbons substituted onto the cyclic structure. An example is adamantane.

In another embodiment of the present invention, the at least one precursor selected from an organosilane and an organosiloxane and (2) the hydrocarbon are part of the same precursor molecule. Accordingly, the structure-forming precursor and the light absorbing precursor are not necessarily different molecules and, in certain embodiments, the light absorber is a part of (e.g., covalently bound to) the structure-forming precursor. Precursors containing light absorbers bound to them are sometimes referred to herein as "light absorbing precursors". For example, it is possible to use phenylmethyldiethoxysilane as a single species, whereby the diethoxysilane portion of the molecule forms the base OSG structure and the bulky phenyl substituent is the light absorbing species. Having the light absorber attached to a Si species that will aid in network formation may be advantageous in achieving a higher efficiency of incorporation of light absorber into the film during the deposition process. Furthermore, it may also be advantageous to have two light absorbers attached to one Si in the precursor, such as in diphenyl-diethoxysilane, or two Si's attached to one light absorber, such as in 1,4-bis(diethoxysilyl)cylcohex-2,5-diene, since a likely bond to break in a plasma during the deposition process is the Si-carbon bond. In this manner, reaction of one Si- light absorber bond in the plasma will still result in incorporation of the light absorbing character in the deposited film.

The following are non-limiting examples of Si-based precursors having light absorbing capability. In the following examples, the light absorbing function is attributed to one or more of R¹, R³ or R⁷:
a) cyclic siloxanes of the formula (OSiR₁R₃)x, where R¹ and R³ are independently H, C₁ to C₁₂, linear or branched, saturated, singly or multiply unsaturated, cyclic, partially or fully fluorinated; and x may be any integer from 2 to 8 (Example: 1-neohexyl-1,3,5,7-tetramethylcyclotetrasiloxane);
b) R¹ₙ(OR²)ₚ(NR³)₄₋₍ₙ₊ₚ₎Si where R¹ is independently H, C₁ to C₁₂, linear or branched, saturated, singly or multiply unsaturated, cyclic, partially or fully fluorinated; R² is independently C₁ to C₁₂, linear or branched, saturated, singly or multiply unsaturated, cyclic, aromatic, partially or fully fluorinated; R³ is independently H, C₁ to C₁₂, linear or branched, saturated, singly or multiply unsaturated, cyclic, aromatic, partially or fully fluorinated; n is 0 to 4; and p is 0 to 4 (Examples: dimethylamino-t-butoxy-neo-hexylsilane, and diethoxy-neo-hexylsilane);
c) R¹ₙ(OR²)ₚ(NR⁴)₃₋ₙ₋ₚSi-O-SiR³ₘ(NR⁵)_{q}(OR⁶)_{3-m-q} where R¹ and R³are independently H, C₁ to C₁₂, linear or branched, saturated, singly or multiply unsaturated, cyclic, partially or fully fluorinated; R² and R⁶ are independently C₁ to C₁₂, linear or branched, saturated, singly or multiply unsaturated, cyclic, aromatic, partially or fully fluorinated; R⁴ and R⁵ are independently H, C₁ to C₁₂, linear or branched, saturated, singly or multiply unsaturated, cyclic, aromatic, partially or fully fluorinated; n is 0 to 3; m is 0 to 3; p is 0 to 3; and q is 0 to 3 (Examples: 1,3-diethylamino-1,3-di-t-butoxy-1-neohexyldisiloxane, and 1,3-diethoxy-1,3-diphenyldisiloxane);
d) R¹ₙ(OR²)ₚ(NR⁴)₃₋ₙ₋ₚSi-SiR³ₘ(NR⁵)_{q}(OR⁶)_{3-m-q} where R¹ and R³are independently H, C₁ to C₁₂, linear or branched, saturated, singly or multiply unsaturated, cyclic, partially or fully fluorinated; R² and R⁶ are independently C₁ to C₁₂, linear or branched, saturated, singly or multiply unsaturated, cyclic, aromatic, partially or fully fluorinated; R⁴ and R⁵ are independently H, C₁ to C₁₂, linear or branched, saturated, singly or multiply unsaturated, cyclic, aromatic, partially or fully fluorinated; n is 0 to 3; m is 0 to 3; p is 0 to 3; and q is 0 to 3 (Examples: 1,2-dipropylamino-1,2-di-t-butoxy-1-neohexyldisilane, and 1,2-diethoxy-1-neo-hexyldisilane);
e) cyclic siloxanes of the formula (OSi(R₁)ₐ(OR₂)_{b}(NR₃)_{c}x, where R¹, R² and R³ are independently H, C₁ to C₁₂, linear or branched, saturated, singly or multiply unsaturated, cyclic, partially or fully fluorinated; a, b, and c are from 0 to 2 and a+b+c = 2; and x is any integer from 2 to 8 (Example: 1,4-bis(dimethoxysilyl)cyclohexane);
f) R¹ₙ(OR²)ₚ(O(O)CR³)₄₋₍ₙ₊ₚ₎Si where R¹ is independently H or C₁ to C₁₂ linear or branched, saturated, singly or multiply unsaturated, cyclic, partially or fully fluorinated hydrocarbon; R² and R³ are independently C₁ to C₁₂ linear or branched, saturated, singly or multiply unsaturated, cyclic, aromatic, partially or fully fluorinated hydrocarbon; n is 0 to 4; and p is 0 to 4, provided that at least one of R¹ is substituted with a C₃ or larger hydrocarbon;
g) R¹(OR²)ₚ(O(O)CR⁴)₃₋ₙ₋ₚSi-O-SiR³ₘ(O(O)CR⁵)_{q}(OR⁶)_{3-m-q} where R¹ and R³ are independently H or C₁ to C₁₂ linear or branched, saturated, singly or multiply unsaturated, cyclic, partially or fully fluorinated hydrocarbon; R², R⁴, R⁵ and R⁶ are independently C₁ to C₁₂ linear or branched, saturated, singly or multiply unsaturated, cyclic, aromatic, partially or fully fluorinated hydrocarbon; n is 0 to 3; m is 0 to 3; q is 0 to 3; and p is 0 to 3, provided that n+p ≤ 3, m+q ≤ 3, and at least one of R¹ and R³ is substituted with a C₃ or larger hydrocarbon;
h) R¹ₙ(OR²)ₚ(O(O)CR⁴)₃₋ₙ₋ₚSi-SiR³ₘ(O(O)CR⁵)_{q}(OR⁶)_{3-m-q} where R¹ and R³ are independently H or C₁ to C₁₂ linear or branched, saturated, singly or multiply unsaturated, cyclic, partially or fully fluorinated hydrocarbon; R², R⁴, R⁵ and R⁶ are independently C₁ to C₁₂ linear or branched, saturated, singly or multiply unsaturated, cyclic, aromatic, partially or fully fluorinated hydrocarbon; n is 0 to 3; m is 0 to 3; q is 0 to 3; and p is 0 to 3, provided that n+p ≤ 3, m+q ≤ 3, and at least one of R¹ and R³ is substituted with a C₃ or larger hydrocarbon;
i) R¹ₙ(OR²)ₚ(O(O)CR⁴)₃₋ₙ₋ₚSi-R⁷-SiR³ₘ(O(O)CR⁵)_{q}(OR⁶)_{3-m-q} where R¹ and R³ are independently H or C₁ to C₁₂ linear or branched, saturated, singly or multiply unsaturated, cyclic, partially or fully fluorinated hydrocarbon; R², R⁴, R⁵, R⁶, and R⁷ are independently C₁ to C₁₂ linear or branched, saturated, singly or multiply unsaturated, cyclic, aromatic, partially or fully fluorinated hydrocarbon, alternatively, R⁷ is an amine or an organoamine group; n is 0 to 3; m is 0 to 3; q is 0 to 3; and p is 0 to 3, provided that n+p ≤ 3, m+q ≤ 3, and at least one of R¹, R³ and R⁷ is substituted with a C₃ or larger hydrocarbon;
j) (R¹ₙ(OR²)ₚ(O(O)CR³)₃₋₍ₙ₊ₚ₎Si)ₜCH₄₋ₜ where R¹ is independently H or C₁ to C₁₂ linear or branched, saturated, singly or multiply unsaturated, cyclic, partially or fully fluorinated hydrocarbon; R² and R³ are independently C₁ to C₁₂ linear or branched, saturated, singly or multiply unsaturated, cyclic, aromatic, partially or fully fluorinated hydrocarbon; n is 0 to 3; p is 0 to 3; and t is 1 to 4, provided that n+p ≤ 4 and at least one of R¹ is substituted with a C₃ or larger hydrocarbon;
k) (R¹ₙ(OR₂)ₚ(O(O)CR³)₃₋₍ₙ₊ₚ₎Si)ₜNH₃₋ₜ where R¹ is independently H or C₁ to C₁₂ linear or branched, saturated, singly or multiply unsaturated, cyclic, partially or fully fluorinated hydrocarbon; R² and R³ are independently C₁ to C₁₂ linear or branched, saturated, singly or multiply unsaturated, cyclic, aromatic, partially or fully fluorinated hydrocarbon; n is 0 to 3; p is 0 to 3; and t is 1 to 3, provided that n+p ≤ 4 and at least one of R¹ is substituted with a C₃ or larger hydrocarbon;
l) cyclic siloxanes of the formula (OSiR₁R₃)ₓ, where R¹ and R³ are independently H or C₁ to C₁₂ linear or branched, saturated, singly or multiply unsaturated, cyclic, partially or fully fluorinated hydrocarbon; and x is any integer from 2 to 8, provided that at least one of R¹ and R³ is substituted with a C₃ or larger hydrocarbon;
m) cyclic silazanes of the formula (NR₁SiR₁R₃)ₓ, where R¹ and R³ are independently H or C₁ to C₁₂ linear or branched, saturated, singly or multiply unsaturated, cyclic, partially or fully fluorinated hydrocarbon; and x is any integer from 2 to 8, provided that at least one of R¹ and R³ is substituted with a C₃ or larger hydrocarbon; or
n) cyclic carbosilanes of the formula (CR₁R₃SiR₁R₃)ₓ, where R¹ and R³are independently H or C₁ to C₁₂ linear or branched, saturated, singly or multiply unsaturated, cyclic, partially or fully fluorinated hydrocarbon; and x is any integer from 2 to 8, provided that at least one of R¹ and R³ is substituted with a C₃ or larger hydrocarbon;
o) R¹ₙ(OR²)ₚ(NR³)₄₋₍ₙ₊ₚ₎Si where R¹ is independently H or C₁ to C₁₂ linear or branched, saturated, singly or multiply unsaturated, cyclic, partially or fully fluorinated hydrocarbon; R² and R³ are independently C₁ to C₁₂ linear or branched, saturated, singly or multiply unsaturated, cyclic, aromatic, partially or fully fluorinated hydrocarbon; n is 0 to 4; and p is 0 to 4, provided that at least one of R¹ is substituted with a C₃ or larger hydrocarbon;
p) R¹ₙ(OR²)ₚ(NR⁴)₃₋ₙ₋ₚSi-O-SiR³ₘ(NR⁵)_{q}(OR⁶)_{3-m-q} where R¹ and R³ are independently H or C₁ to C₁₂ linear or branched, saturated, singly or multiply unsaturated, cyclic, partially or fully fluorinated hydrocarbon; R², R⁴, R⁵ and R⁶ are independently C₁ to C₁₂ linear or branched, saturated, singly or multiply unsaturated, cyclic, aromatic, partially or fully fluorinated hydrocarbon; n is 0 to 3; m is 0 to 3; q is 0 to 3; and p is 0 to 3, provided that n+p ≤ 3, m+q ≤ 3, and at least one of R¹ and R³ is substituted with a C₃ or larger hydrocarbon;
q) R¹ₙ(OR²)ₚ(NR⁴)₃₋ₙ₋ₚSi-SiR³(NR⁵)_{q}(OR⁶)_{3-m-q} where R¹ and R³ are independently H or C₁ to C₁₂ linear or branched, saturated, singly or multiply unsaturated, cyclic, partially or fully fluorinated hydrocarbon; R², R⁴, R⁵ and R⁶ are independently C₁ to C₁₂ linear or branched, saturated, singly or multiply unsaturated, cyclic, aromatic, partially or fully fluorinated hydrocarbon; n is 0 to 3; m is 0 to 3; q is 0 to 3; and p is 0 to 3, provided that n+p ≤ 3, m+q ≤ 3, and at least one of R¹ and R³ is substituted with a C₃ or larger hydrocarbon;
r) R¹ₙ(OR²)ₚ(NR⁴)₃₋ₙ₋ₚSi-R⁷-SiR³ₘ(NR⁵)_{q}(OR⁶)_{3-m-q} where R¹ and R³ are independently H or C₁ to C₁₂ linear or branched, saturated, singly or multiply unsaturated, cyclic, partially or fully fluorinated hydrocarbon; R², R⁴, R⁵, R⁶, and R⁷ are independently C₁ to C₁₂ linear or branched, saturated, singly or multiply unsaturated, cyclic, aromatic, partially or fully fluorinated hydrocarbon, alternatively, R⁷ is an amine or an organoamine group; n is 0 to 3; m is 0 to 3; q is 0 to 3; and p is 0 to 3, provided that n+p ≤ 3, m+q ≤ 3, and at least one of R¹, R³ and R⁷ is substituted with a C₃ or larger hydrocarbon;
s) (R¹ₙ(OR²)ₚ(NR³)₃₋₍ₙ₊ₚ₎Si)ₜCH₄₋ₜ where R¹ is independently H or C₁ to C₁₂ linear or branched, saturated, singly or multiply unsaturated, cyclic, partially or fully fluorinated hydrocarbon; R² and R³ are independently C₁ to C₁₂ linear or branched, saturated, singly or multiply unsaturated, cyclic, aromatic, partially or fully fluorinated hydrocarbon; n is 0 to 4; p is 0 to 4; and t is 1 to 4, provided that n+p ≤ 4 and at least one of R¹ is substituted with a C₃ or larger hydrocarbon;
t) (R¹ₙ(OR²)ₚ(NR³)₃₋₍ₙ₊ₚ₎Si)ₜNH₃₋ₜ where R¹ is independently H or C₁ to C₁₂ linear or branched, saturated, singly or multiply unsaturated, cyclic, partially or fully fluorinated hydrocarbon; R² and R³ are independently C₁ to C₁₂ linear or branched, saturated, singly or multiply unsaturated, cyclic, aromatic, partially or fully fluorinated hydrocarbon; n is 0 to 3; p is 0 to 3; and t is 1 to 3, provided that n+p ≤ 4 and at least one of R¹ is substituted with a C₃ or larger hydrocarbon;
u) cyclic siloxanes of the formula (OSi(R₁)ₐ(OR₂)_{b}(NR₃)_{c})X, where R¹, R² and R³ are independently H or C₁ to C₁₂ linear or branched, saturated, singly or multiply unsaturated, cyclic, partially or fully fluorinated hydrocarbon; and x is any integer from 2 to 8; a, b, and c are from 0 to 2 and a+b+c = 2, provided that at least one of R¹, R², and R³ is substituted with a C₃ or larger hydrocarbon;
v) cyclic silazanes of the formula (NR₁Si(R₁)ₐ(OR₂)_{b}(NR₃)_{c})X, where R¹, R², and R³ are independently H or C₁ to C₁₂ linear or branched, saturated, singly or multiply unsaturated, cyclic, partially or fully fluorinated hydrocarbon, and x is any integer from 2 to 8, a, b, and c are from 0 to 2 and a+b+c = 2, provided that at least one of R¹ and R³ is substituted with a C₃ or larger hydrocarbon; and
w) cyclic carbosilanes of the formula (CR₁R₃Si(OR₂)_{b}(NR₃)_{c})X, where R¹, R², and R³ are independently H or C₁ to C₁₂ linear or branched, saturated, singly or multiply unsaturated, cyclic, partially or fully fluorinated hydrocarbon; x is any integer from 2 to 8; and b and c are from 0 to 2 and b+c = 2, provided that at least one of R¹, R² and R³ is substituted with a C₃ or larger hydrocarbon.

It is preferred that at least one of R¹, R³ and R⁷ have a C₃ or larger hydrocarbon to act as light absorber, and an optional post-treatment process may be used to modify at least a portion of the light absorber. In certain preferred embodiments of the present invention each of R¹, R², R³, R⁴, and R⁷ in the formulas above are either hydrogen or a C₅ to C₇ hydrocarbon group.

The above precursors may be mixed with other molecules of these same classes and/or with molecules of the same classes except where n and/or m are from 0 to 3.

In all of the above-described embodiments, the hydrocarbon (i.e., the light-absorbing component) preferably is substantially not removed from the antireflective coating. As used herein, the phrase "substantially not removed from the antireflective coating" refers to a feature of the present invention wherein carbon species from the hydrocarbon are desired to be present to participate in imparting antireflective character to the coating. Accordingly, although some carbon may be incidentally removed as a result of certain processing conditions after antireflective layer 104 has been deposited, the carbon is substantially present in the coating to absorb light at the required wavelengths.

In preferred embodiments of the present invention, antireflective layer 104 is a thin film having not only light absorbing characteristics, but also improved etch resistance, structural integrity, mechanical properties, thermal stability, and chemical resistance (to oxygen, aqueous oxidizing environments, etc.) relative to, for example, organic polymeric anti-reflective materials.

In preferred embodiments of the present invention, antireflective layer 104 comprises: (a) 1 to 35 atomic% silicon; (b) 1 to 40 atomic% oxygen; (c) 10 to 50 atomic% hydrogen; and (d) 5 to 80 atomic% carbon. Films may also contain 0.1 to 50 atomic % nitrogen, and/or from 0.1 to 15 atomic % fluorine, to improve one or more of materials properties. Lesser portions of other elements may also be present in certain films of the invention. The film of the present invention, thus, is a composite material, as opposed to an organic antireflective material, which lacks the structural integrity and film properties provided by the incorporation of inorganic groups.

Antireflective coatings of the present invention do not require the use of an oxidant to during deposition of the film. The absence of added oxidant to the gas phase, which is defined for present purposes as a moiety that could oxidize organic groups (e.g., O₂, N₂O, ozone, hydrogen peroxide, NO, NO₂, N₂O₄, or mixtures thereof), may facilitate the retention of the desired light absorbing species in the film. This allows the incorporation of the desired amount of carbon necessary to provide desired properties, such as light absorptivity and etch resistance.

Antireflective coatings of the present invention may also contain fluorine, in the form of organic (C-Fₙ) or inorganic fluorine (e.g., Si-F).

The antireflective coatings of the present invention are compatible with the various chemical processes used to produce electronic devices, and are capable of adhering to a variety of materials, such as silicon, SiO₂, Si₃N₄, OSG, FSG, silicon carbide, hydrogenated silicon carbide, silicon nitride, hydrogenated silicon nitride, silicon carbonitride, hydrogenated silicon carbonitride, boronitride, low dielectric constant materials, photoresists, organic polymers, porous organic and inorganic materials, metals such as copper and aluminum, and diffusion barrier layers such as but not limited to TiN, Ti(C)N TaN, Ta(C)N, Ta, W, WN or W(C)N. Such films are capable of adhering to at least one of the foregoing materials sufficiently to pass a conventional pull test, such as ASTM D3359-95a tape pull test, wherein a sample is considered to have passed the test if there is no discernible removal of film.

Preferably, the antireflective coating 104 is deposited to a thickness of from 0.002 to 10 microns, although the thickness can be varied as required. The blanket film deposited on a non-patterned surface has excellent uniformity, with a variation in thickness of less than 2% over 1 standard deviation across the substrate with a reasonable edge exclusion, wherein e.g., a 5mm outermost edge of the substrate is not included in the statistical calculation of uniformity.

The absorptivity of the film can be increased by altering the chemistry and deposition conditions for the film, as well as with optional post-treatments in order to tailor the film properties for the particular application.

The precursors can be carried into the reactor separately from distinct sources or as a mixture. The precursors can be delivered to the reactor system by any number of means, preferably using a pressurizable stainless steel vessel fitted with the proper valves and fittings to allow the delivery of liquid to the process reactor.

In certain embodiments, mixtures of different precursors such as, for example, organosilanes and/or organosiloxanes and or aminosilanes, are used in combination. It is also within the scope of the invention to use combinations of multiple different light absorbers, and organosilanes and/or organosiloxanes and/or aminosilanes in combination with, for example, organosilane and/or organosiloxane species with attached light absorbers. Such embodiments facilitate adjusting the ratio of light absorber to Si in the final product, and /or enhance one or more critical properties of the structure. For example, a deposition utilizing diethoxymethylsilane (DEMS) as the primary source of light absorbing functionality might use an additional organosilicon such as, for example, tetraethoxysilane (TEOS) to improve the film's mechanical strength. A similar example may be the use of DEMS added to the reaction using the organosilicon phenylmethyldiethoxysilane, where the phenyl group bound to the precursor functions as the light absorber. A further example would be the addition of di-tert-butoxy-diacetoxysilane to the reaction using diphenylsilane and light absorber. In certain embodiments, a mixture of a first organosilicon precursor with two or fewer Si-O bonds with a second organosilicon precursor with three or more Si-O bonds, is provided to tailor a chemical composition of the inventive film.

In addition to the structure forming species and the light absorbing species, additional materials can be charged into the vacuum chamber prior to, during and/or after the deposition reaction. Such materials include, e.g., inert gas (e.g., He, Ar, N₂, Kr, Xe, which may be employed as a carrier gas for lesser volatile precursors and/or which can promote the curing of the as-deposited materials and provide a more stable final film) and reactive substances, such as gaseous or liquid organic substances, NH₃, H₂, CO₂, or CO. CO₂ is the preferred carrier gas.

Energy is applied to the gaseous reagents to induce the gases to react and to form the film on the substrate. Such energy can be provided by, e.g., thermal, plasma, pulsed plasma, helicon plasma, high density plasma, inductively coupled plasma, and remote plasma methods. A secondary rf frequency source can be used to modify the plasma characteristics at the substrate surface. Preferably, the film is formed by plasma enhanced chemical vapor deposition. It is particularly preferred to generate a capacitively coupled plasma at a frequency of 13.56 MHz. Plasma power is preferably from 0.02 to 7 watts/cm², more preferably 0.3 to 3 watts/cm², based upon a surface area of the substrate. It may be advantageous to employ a carrier gas which possesses a low ionization energy to lower the electron temperature in the plasma which in turn will cause less fragmentation in the OSG precursor and light absorber. Examples of this type of low ionization gas include CO₂, NH₃, CO, CH₄, Ar, Xe, Kr.

The flow rate for each of the gaseous reagents preferably ranges from 10 to 5000 sccm, more preferably from 30 to 1000 sccm, per single 200 mm wafer. The individual rates are selected so as to provide the desired amounts of structure-former and pore-former in the film. The actual flow rates needed may depend upon wafer size and chamber configuration, and are in no way limited to 200 mm wafers or single wafer chambers.

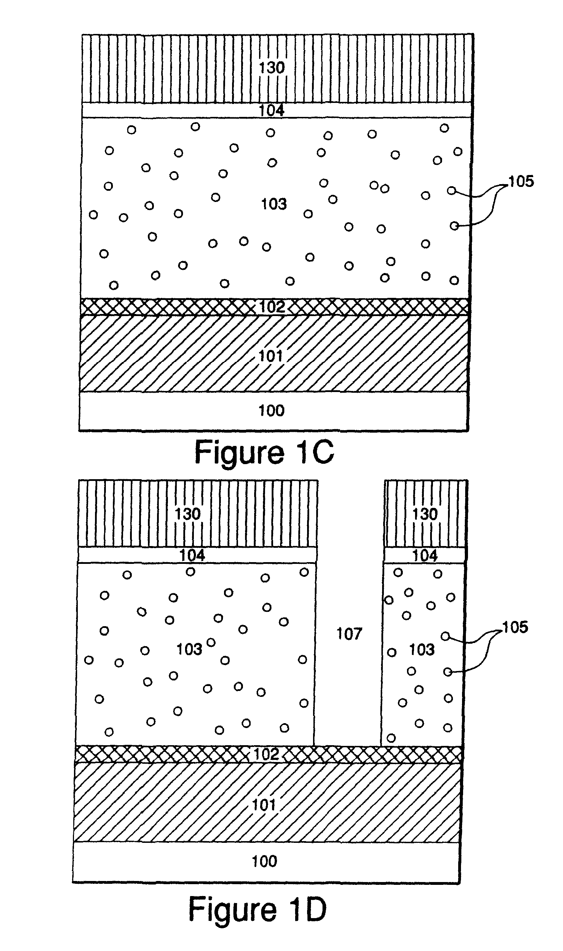

After forming antireflective coating 104, a photoresist layer 130 can be patterned on top of it to define, for example, a via formation region for receiving a subsequently formed conductive layer that will contact conductive layer 101. Photoresist layer 130 may be patterned using conventional photolithographic techniques, such as masking the layer of photoresist, exposing the masked layer to light, then developing the photoresist layer. The resulting structure is shown in FIG. 1C, which depicts a structure formed during manufacture of a semiconductor device, the structure comprising: a patternable layer 103 formed above a substrate 100; an antireflective coating 104 formed over the patternable layer 103, preferably wherein the antireflective coating 104 is represented by the formula SiᵥO_{w}CₓNᵤH_{y}F_{z}, wherein v+w+x+u+y+z = 100%, v is from 10 to 35 atomic%, w is from 5 to 65 atomic%, x is from 5 to 80 atomic%, u is from 0 to 50 atomic %, y is from 10 to 50 atomic% and z is from 0 to 15 atomic%; and a photoresist pattern 130 formed over the antireflective coating 104, wherein the antireflective coating is formed by the chemical vapor deposition of (1) at least one precursor selected from an organosilane, an organosiloxane, and an aminosilane; and (2) a hydrocarbon; and preferably wherein the hydrocarbon is substantially not removed from the antireflective coating.

After photoresist layer 130 is patterned, via 107 is etched through porous dielectric layer 103 down to barrier layer 102, which acts as an etch stop. Conventional process steps for etching through a dielectric layer may be used to etch the via, e.g., a conventional anisotropic dry etch process. An isotropic or anisotropic forming gas ash may then be applied at an appropriate temperature and pressure to remove the photoresist. A via clean step may follow to produce the structure shown in FIG. 1 D.

After via 107 is etched, the remaining portion of antireflective coating 104 and photoresist 130 must be removed. This is preferably accomplished by employing a process that provides a significantly higher removal rate of the antireflective coating 104 and photoresist 130 than that of porous dielectric layer 103. In some embodiments of the present invention, the remaining portion of antireflective coating 104 and photoresist 130 is removed by a dry etch process that removes remaining portions of antireflective coating 104 and photoresist 130 at a significantly higher rate than it removes porous dielectric layer 103.

In preferred embodiments of the present invention, wet etch chemicals that may be employed include, for example, solvents and/or stripper formulations. Solvents can be, for example, alcohol solvents, ketone solvents, amide solvents, or ester solvents. In certain embodiments the solvents may be a supercritical fluid such as carbon dioxide, fluorocarbons, sulfur hexafluoride, alkanes, and other suitable multi-component compositions, etc. In certain embodiments, one or more solvents used in the present invention have relatively low boiling points, *i*.*e*., below 160°C. These solvents include, but are not limited to, tetrahydrofuran, acetone, 1,4-dioxane, 1,3-dioxolane, ethyl acetate, and methyl ethyl ketone. Other solvents, that can be used in the present invention but have boiling points above 160°C, include dimethylformamide, dimethylacetamide, N-methyl pyrrolidone, ethylene carbonate, propylene carbonate, glycerol and derivatives, naphthalene and substituted versions, acetic acid anyhydride, propionic acid and propionic acid anhydride, dimethyl sulfone, benzophenone, diphenyl sulfone, phenol, m-cresol, dimethyl sulfoxide, diphenyl ether, terphenyl, and the like. Preferred solvents include propylene glycol propyl ether (PGPE), 3-heptanol, 2-methyl-1-pentanol, 5-methyl-2-hexanol, 3-hexanol, 2-heptano, 2-hexanol, 2,3-dimethyl-3-pentanol, propylene glycol methyl ether acetate (PGMEA), ethylene glycol n-butyl ether, propylene glycol n-butyl ether (PGBE), 1-butoxy-2-propanol, 2-methyl-3-pentanol, 2-methoxyethyl acetate, 2-butoxyethanol, 2-ethoxyethyl acetoacetate, 1-pentanol, and propylene glycol methyl ether. Still further exemplary solvents include lactates, pyruvates, and diols. Further exemplary solvents include those solvents listed in EP 1,127,929. The solvents enumerated above may be used alone or in combination of two or more solvents.

The wet removal can be conducted using one or more stripper formulations. These formulations can be solvent-based, aqueous-based, amine-containing, fluoride-containing, buffered or combinations thereof. The selection of the particular formulation depends upon the identity of the porous dielectric and porous sacrificial light absorbing materials to be removed. Examples of suitable stripper formulations include those described in U. S. Issued Pat. Nos. 6,583,104, 6,677,286, 6,627,546, 6,828,289 and U.S. Published Patent Applications 2004/0266637, 2004/0063042, 2003/0130146, and 2003/0148910.

Although the benefits of the antireflective coating of the present invention have been demonstrated in connection with etching a dielectric material, one of ordinary skill in the art will understand that the antireflective coatings of the present invention can be employed in connection with etching other substrates such as, for example, silicon, aluminum, metals, metal oxides, and barrier materials.

The invention will be illustrated in more detail with reference to the following Examples, but it should be understood that the present invention is not deemed to be limited thereto.

### EXAMPLES

All experiments were performed on an Applied Materials Precision-5000 system in a 200mm DxZ chamber fitted with an Advance Energy 2000 rf generator, using an undoped TEOS process kit. The recipe involved the following basic steps: initial set-up and stabilization of gas flows, deposition, and purge/evacuation of chamber prior to wafer removal. Thickness, refractive index, and extinction coefficient were measured on an SCI Filmtek 2000 Reflectometer.

### Example 1: BTBAS (aminosilane)

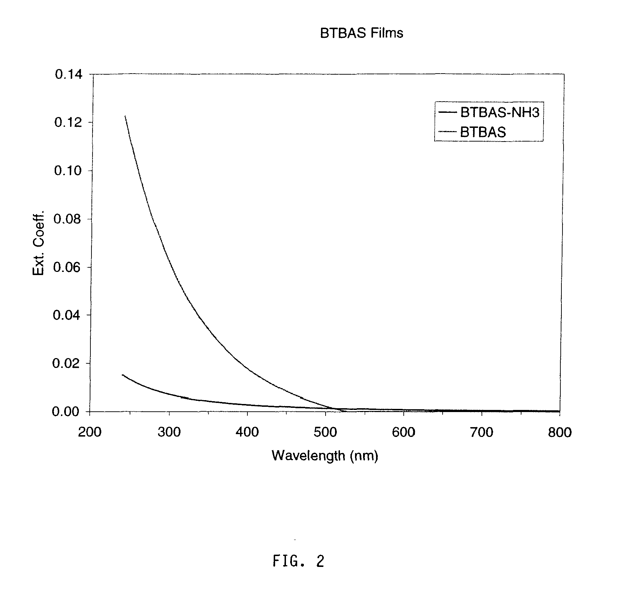

Films were deposited on silicon wafers by PECVD techniques using bis t-butylamino silane (BTBAS). The wafers were processed in a 200 mm Applied Materials DxZ PECVD chamber having a susceptor temperature of 150 °C. Deposition conditions are summarized in Table 1. Once the BTBAS (200 mgm) and N₂ (750 sccm) flow rates were established, the pressure was stabilized at 3.0 torr (400 Pa). RF power (13.56 MHz, 200W) was then applied for 120 seconds to deposit the SiᵥO_{w}NₓC_{y}H_{z} films. Following deposition, the silicon wafers were removed from the PECVD chamber and the chamber was cleaned using a NF₃ plasma. Film thickness (190 nm) and refractive index (1.53) of the SiᵥO_{w}NₓC_{y}H_{z} films were measured using reflectometry. The absortivity of the films is shown in Fig. 2 by plotting the extinction coefficient over the wavelength range 240-950 nm.

**Table 1: Deposition conditions and film properties for the BTBAS examples**

| | | | | | | | | |
|---|---|---|---|---|---|---|---|---|
| | BTBAS (mgm) | N₂ (sccm) | NH₃ (sccm) | P (torr (Pa)) | RF (W) | T (C) | d (nm) | RI |
| BTBAS | 200 | 750 | 0 | 3.0(400) | 200 | 150 | 190 | 1.53 |
| BTBAS-NH₃ | 400 | 200 | 500 | 2.5 (330) | 400 | 150 | 816 | 1.49 |

### Example 2: BTBAS-NH₃

SiᵥO_{w}NₓC_{y}H_{z} films were deposited on silicon wafers by PECVD techniques using bis t-butylamino silane (BTBAS) and ammonia (NH₃). The wafers were processed in a 200 mm Applied Materials DxZ PECVD chamber having a susceptor temperature of 150 °C. Deposition conditions are summarized in Table 1 above. Once the BTBAS (200 mgm), N₂ (200 sccm), and NH₃ (500 sccm) flow rates are established, the pressure was stabilized at 2.5 torr (330 Pa). RF power (13.56 MHz, 400W) was then applied for 300 s to deposit the SiᵥO_{w}NₓC_{y}H_{z} films. Following deposition, the silicon wafers were removed from the PECVD chamber and the chamber cleaned using a NF₃ plasma. Film thickness (816 nm) and refractive index (1.49) of the SiᵥO_{w}NₓC_{y}H_{z} films were measured using reflectometry. The absortivity of the films is shown in Fig. 2 by plotting the extinction coefficient over the wavelength range 240-950 nm.

### Example 3: DEMS and ATRP

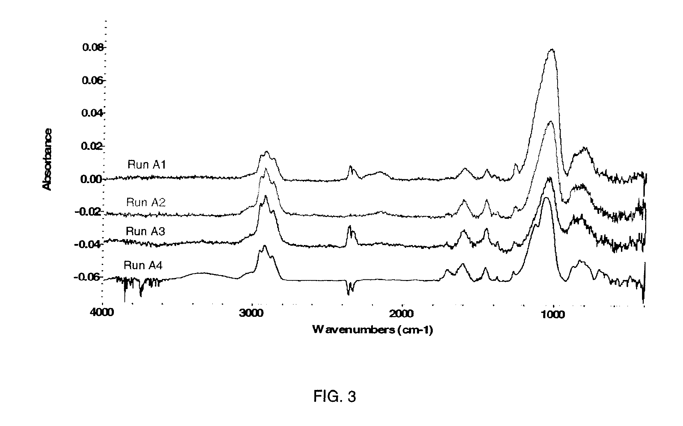

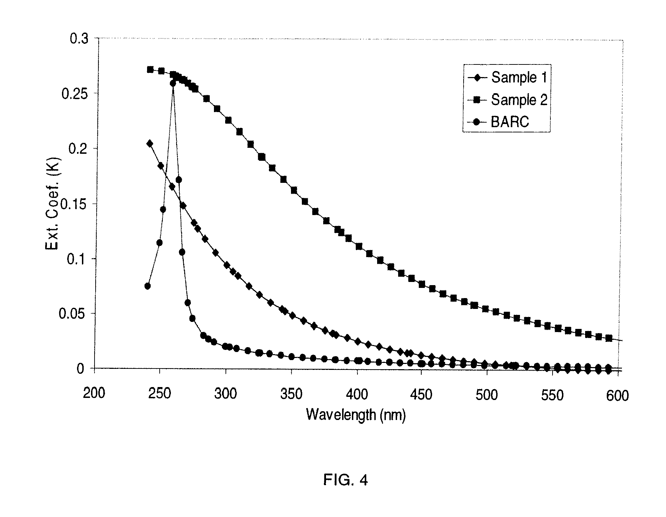

Referring to Table 2, organic-inorganic composite materials were co-deposited from Alpha-terpinene (ATRP) and diethoxymethylsilane (DEMS) onto a silicon wafer via PECVD. Referring to the second run, A2, for example, the process conditions were 540 miligrams per minute (mgm) flow of ATRP and 60 mgm DEMS. A carrier gas flow of 200 sccm of CO₂ was used to escort the chemicals into the deposition chamber. Further process conditions were as follows: a chamber pressure of 5 Torr (670 Pa), wafer chuck temperature of 400°C, showerhead to wafers spacing of 0.35 inches, and plasma power of 800 watts. These films indicated significant hydrocarbon content as shown by Figure 3, FT-IR absorptions near 3000 cm-1. Also observed are strong C=C absorptions (∼1600 cm⁻¹). These materials provided extinction coefficient profiles as shown in Figure 4 relative to commercial spin-on anti-reflective coating materials. After UV exposure the measured refractive index and extinction coefficient generally increases from about 1.65 to 1.72.

These deposition conditions are significantly more aggressive than those used for a typical porous OSG deposition. For example, depositions according to the present invention were performed at 400 °C, 5 torr (670 Pa), and an rf power of 800 W; in a typical deposition process for making a porous OSG film the temperature would be less than 300 °C, the reaction pressures would be 8-10 torr (1.1-1.3 kPa), and the rf power would be around 500-600 W. The modification of reaction conditions to achieve antireflective coatings of the present invention render the plasma significantly more aggressive, resulting in carbon that is substantially retained throughout further processing.

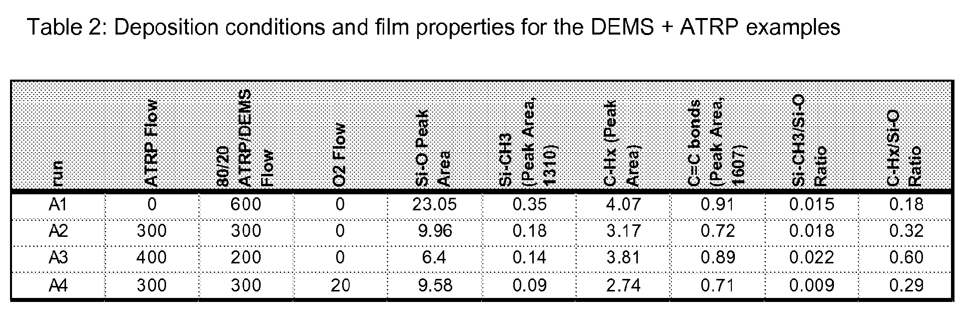

Etch rate tests were performed in an AMAT Mark II RIE chamber using 26 sccm C₄F₈, 7 sccm 02, 168 sccm Ar, 1000 Watts of 13.56 MHz rf power, 50 Gauss (0.005 Telsa), at 35 mtorr (4.7 Pa) pressure. Etch rates for pre- and post-UV exposed films were - 120 nm/min, compared to etch rates of > 300nm/min for SiO₂ and porous OSG (k=2.5) films at the same conditions. The IR spectrum of the antireflective coating was unchanged post-etching relative to it's pre-etching spectrum.

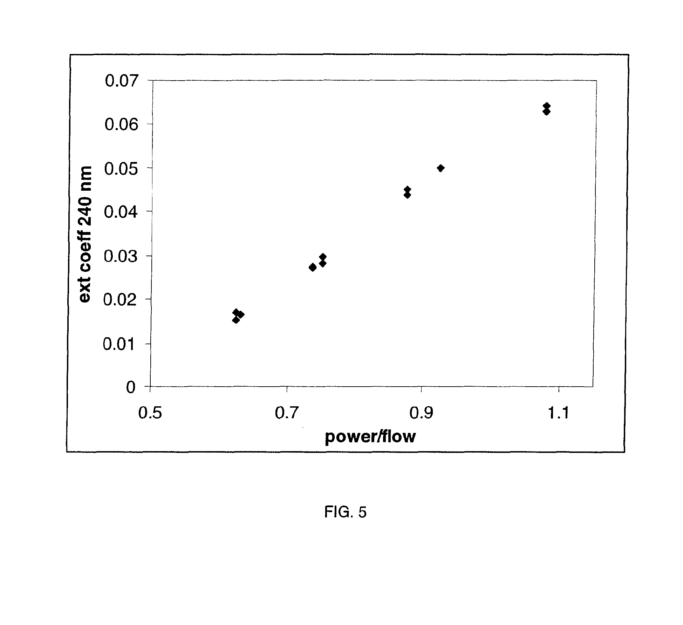

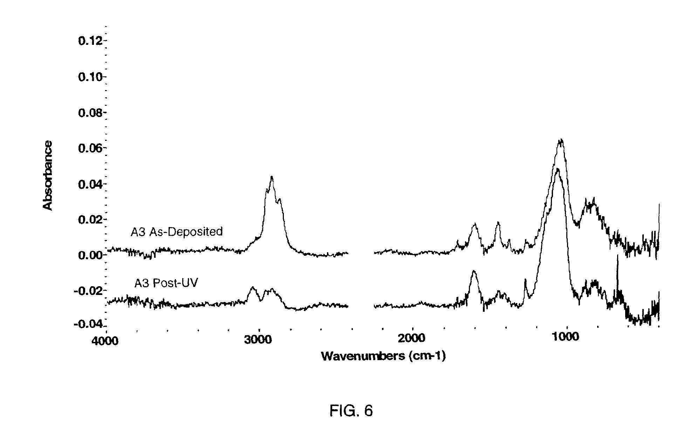

Figure 5 (tailoring film absorptivity) indicates how the absorptive character of the film can be tailored through changes in processing conditions. In this example only the relative power density, or rf power per unit flow of chemical, is being adjusted. Note that this parameter does not take into account changes in residence time for the chemical, which changes with chemical flow rate. As the power density increases there is a linear increase in the extinction coefficient (@240nm), indicating a material with a higher propensity to absorb UV light. In other words, employing more aggressive deposition conditions such as, for example, higher power densities, the carbon incorporated into the film is retained throughout processing conditions. This is in contrast to processes employed to produce porous organosilicate glass materials by PECVD wherein labile carbon is incorporated into the film with the intention of removing it. For example, Figure 6 shows the FTIR spectrum of an antireflective coating (A3, above) according to the present invention both before and after exposure to high-powered UV that is typically employed to remove carbon from, for example, an organosilicate glass film. It can be seen in Figure 6 that there is a conversion of alkyl carbon to aromatic carbon and a retention of C=C structure. The dielectric constant of the film shown in Figure 6 before UV exposure was 3.65 and the dielectric constant of the film shown in Figure 6 after UV exposure was 3.75. This indicates little change, if any, in the carbon content of the film.

## Claims

1. A method of forming a feature in a substrate comprising the steps of:
forming a dielectric layer on a substrate;
forming an antireflective coating over the dielectric layer;
forming a photoresist pattern over the antireflective coating;
etching the dielectric layer through the patterned photoresist; and
removing the antireflective coating and the photoresist,
wherein the antireflective coating is a film represented by the formula SiᵥO_{w}CₓNᵤH_{y}F_{z}, wherein v+w+x+u+y+z = 100%, v is from 1 to 35 atomic%, w is from 1 to 65 atomic%, x is from 5 to 80 atomic%, u is from 0 to 50 atomic %, y is from 10 to 50 atomic% and z is from 0 to 15 atomic%,
wherein the antireflective coating is formed by the chemical vapor deposition of a composition comprising (1) at least one precursor selected from an organosilane, an organosiloxane, and an aminosilane; and (2) a hydrocarbon, and
wherein the hydrocarbon is substantially not removed from the antireflective coating.

2. The method of Claim 1 wherein the dielectric layer is porous.

3. The method of Claim 1 or 2 wherein the antireflective coating is a hardmask.

4. The method of any preceding claim wherein the hydrocarbon is distinct from the at least one precursor.

5. The method of any preceding claim wherein the antireflective coating is formed by the chemical vapor deposition of a composition comprising an aminosilane and a hydrocarbon.

6. The method of Claim 5 wherein the aminosilane is bis(tertiarybutylamino)silane.

7. The method of Claim 4 wherein the at least one precursor is at least one selected from:
(a) the formula R¹ₙ(OR²)ₚ(O(O)CR³)₄₋₍ₙ₊ₚ₎Si where R¹ is independently H or C₁ to C₄ linear or branched, saturated, singly or multiply unsaturated, cyclic, partially or fully fluorinated hydrocarbon; R² is independently C₁ to C₆ linear or branched, saturated, singly or multiply unsaturated, cyclic, aromatic, partially or fully fluorinated hydrocarbon; R³ is independently H, C₁ to C₆ linear or branched, saturated, singly or multiply unsaturated, cyclic, aromatic, partially or fully fluorinated hydrocarbon; n is 0 to 4; p is 0 to 4; and n+p ≤ 4;
(b) the formula R¹ₙ(OR²)ₚ(O(O)CR⁴)₃₋ₙ₋ₚSi-O-SiR³ₘ(O(O)CR⁵)_{q}(OR⁶)_{3-m-q} where R¹ and R³ are independently H or C₁ to C₄ linear or branched, saturated, singly or multiply unsaturated, cyclic, partially or fully fluorinated hydrocarbon; R² and R⁶ are independently C₁ to C₆ linear or branched, saturated, singly or multiply unsaturated, cyclic, aromatic, partially or fully fluorinated hydrocarbon; R⁴ and R⁵ are independently H, C₁ to C₆ linear or branched, saturated, singly or multiply unsaturated, cyclic, aromatic, partially or fully fluorinated hydrocarbon; n is 0 to 3; m is 0 to 3; q is 0 to 3; and p is 0 to 3, provided that n+p ≤ 3 and m+q ≤ 3;
(c) the formula R¹ₙ(OR²)ₚ(O(O)CR⁴)₃₋ₙ₋ₚSi-SiR³ₘ(O(O)CR⁵)_{q}(OR⁶)_{3-m-q} where R¹ and R³ are independently H or C₁ to C₄ linear or branched, saturated, singly or multiply unsaturated, cyclic, partially or fully fluorinated hydrocarbon; R² and R⁶ are independently C₁ to C₆ linear or branched, saturated, singly or multiply unsaturated, cyclic, aromatic, partially or fully fluorinated hydrocarbon; R⁴ and R⁵ are independently H, C₁ to C₆ linear or branched, saturated, singly or multiply unsaturated, cyclic, aromatic, partially or fully fluorinated hydrocarbon; n is 0 to 3; m is 0 to 3; q is 0 to 3; and p is 0 to 3, provided that n+p ≤ 3 and m+q ≤ 3;
(d) the formula R¹ₙ(OR²)ₚ(O(O)CR⁴)₃₋ₙ₋ₚSi-R⁷-SiR³ₘ(O(O)CR⁵)_{q}(OR⁶)_{3-m-q} where R¹ and R³ are independently H or C₁ to C₄ linear or branched, saturated, singly or multiply unsaturated, cyclic, partially or fully fluorinated hydrocarbon; R², R⁶ and R⁷ are independently C₁ to C₆ linear or branched, saturated, singly or multiply unsaturated, cyclic, aromatic, partially or fully fluorinated hydrocarbon, alternatively, R⁷ is an amine or an organoamine group; R⁴ and R⁵ are independently H, C₁ to C₆ linear or branched, saturated, singly or multiply unsaturated, cyclic, aromatic, partially or fully fluorinated hydrocarbon; n is 0 to 3; m is 0 to 3; q is 0 to 3; and p is 0 to 3, provided that n+p ≤ 3, and m+q ≤ 3;
(e) the formula (R¹ₙ(OR²)ₚ(O(O)CR³)₃₋₍ₙ₊ₚ₎Si)ₜCH₄₋ₜ where R¹ is independently H or C₁ to C₄ linear or branched, saturated, singly or multiply unsaturated, cyclic, partially or fully fluorinated hydrocarbon; R² is independently C₁ to C₆ linear or branched, saturated, singly or multiply unsaturated, cyclic, aromatic, partially or fully fluorinated hydrocarbon; R³ is independently H, C₁ to C₆ linear or branched, saturated, singly or multiply unsaturated, cyclic, aromatic, partially or fully fluorinated hydrocarbon; n is 0 to 3; p is 0 to 3; and t is 2 to 4, provided that n+p ≤ 3;
(f) the formula (R¹ₙ(OR²)ₚ(O(O)CR³)₃₋₍ₙ₊ₚ₎Si)ₜNH₃₋ₜ where R¹ is independently H or C₁ to C₄ linear or branched, saturated, singly or multiply unsaturated, cyclic, partially or fully fluorinated hydrocarbon; R² is independently C₁ to C₆ linear or branched, saturated, singly or multiply unsaturated, cyclic, aromatic, partially or fully fluorinated hydrocarbon; R³ is independently H, C₁ to C₆ linear or branched, saturated, singly or multiply unsaturated, cyclic, aromatic, partially or fully fluorinated hydrocarbon; n is 0 to 3; p is 0 to 3; and t is 1 to 3, provided that n+p ≤ 3;
(g) cyclic siloxanes of the formula (OSiR¹R³)ₓ, where R¹ and R³ are independently H or C₁ to C₄, linear or branched, saturated, singly or multiply unsaturated, cyclic, partially or fully fluorinated hydrocarbon; and x is any integer from 2 to 8;
(h) cyclic silazanes of the formula (NR¹SiR¹R³)ₓ, where R¹ and R³ are independently H or C₁ to C₄, linear or branched, saturated, singly or multiply unsaturated, cyclic, partially or fully fluorinated hydrocarbon; and x is any integer from 2 to 8;
(i) cyclic carbosilanes of the formula (CR¹R³SiR¹R³)ₓ, where R¹ and R³ are independently H or C₁ to C₄, linear or branched, saturated, singly or multiply unsaturated, cyclic, partially or fully fluorinated hydrocarbon; and x is any integer from 2 to 8;
(k) the formula R¹ₙ(OR²)ₚ(NR³_{z})₄₋₍ₙ₊ₚ₎Si where R¹ is independently H or C₁ to C₄ linear or branched, saturated, singly or multiply unsaturated, cyclic, partially or fully fluorinated hydrocarbon; R² is independently C₁ to C₆ linear or branched, saturated, singly or multiply unsaturated, cyclic, aromatic, partially or fully fluorinated hydrocarbon; R³ is independently H, C₁ to C₆ linear or branched, saturated, singly or multiply unsaturated, cyclic, aromatic, partially or fully fluorinated hydrocarbon; z is 1 or 2; n is 0 to 3; p is 0 to 3; and n+p ≤ 3;
(l) the formula R¹ₙ(OR²)ₚ(NR⁴_{z})₃₋ₙ₋ₚSi-O-SiR³ₘ(NR⁵)_{q}(OR⁶)_{3-m-q} where R¹ and R³ are independently H or C₁ to C₄ linear or branched, saturated, singly or multiply unsaturated, cyclic, partially or fully fluorinated hydrocarbon; R² and R⁶ are independently C₁ to C₆ linear or branched, saturated, singly or multiply unsaturated, cyclic, aromatic, partially or fully fluorinated hydrocarbon; R⁴ and R⁵ are independently H, C₁ to C₆ linear or branched, saturated, singly or multiply unsaturated, cyclic, aromatic, partially or fully fluorinated hydrocarbon; z is 1 or 2; n is 0 to 3; m is 0 to 3; q is 0 to 3; and p is 0 to 3, provided that n+p ≤ 3 and m+q ≤ 3;
(m) the formula R¹ₙ(OR²)ₚ(NR⁴_{z})₃₋ₙ₋ₚSi-SiR³ₘ(NR⁵_{z})_{q}(OR⁶)_{3-m-q} where R¹ and R³ are independently H or C₁ to C₄ linear or branched, saturated, singly or multiply unsaturated, cyclic, partially or fully fluorinated hydrocarbon; R² and R⁶ are independently C₁ to C₆ linear or branched, saturated, singly or multiply unsaturated, cyclic, aromatic, partially or fully fluorinated hydrocarbon; R⁴ and R⁵ are independently H, C₁ to C₆ linear or branched, saturated, singly or multiply unsaturated, cyclic, aromatic, partially or fully fluorinated hydrocarbon; z is 1 or 2; n is 0 to 3; m is 0 to 3; q is 0 to 3; and p is 0 to 3, provided that n+p ≤ 3 and m+q ≤ 3;
(n) the formula R¹ₙ(OR²)ₚ(NR⁴_{z})₃₋ₙ₋ₚSi-R⁷-SiR³ₘ(NR⁵_{z})_{q}(OR⁶)_{3-m-q} where R¹ and R³ are independently H or C₁ to C₄ linear or branched, saturated, singly or multiply unsaturated, cyclic, partially or fully fluorinated hydrocarbon; R², R⁶ and R⁷ are independently C₁ to C₆ linear or branched, saturated, singly or multiply unsaturated, cyclic, aromatic, partially or fully fluorinated hydrocarbon, alternatively, R⁷ is an amine or an organoamine group; R⁴ and R⁵ are independently H, C₁ to C₆ linear or branched, saturated, singly or multiply unsaturated, cyclic, aromatic, partially or fully fluorinated hydrocarbon; z is 1 or 2; n is 0 to 3; m is 0 to 3; q is 0 to 3; and p is 0 to 3, provided that n+p ≤ 3, and m+q ≤ 3;
(o) the formula (R¹ₙ(OR²)ₚ(NR³_{z})₃₋₍ₙ₊ₚ₎Si)ₜCH₄₋ₜ where R¹ is independently H or C₁ to C₄ linear or branched, saturated, singly or multiply unsaturated, cyclic, partially or fully fluorinated hydrocarbon; R² is independently C₁ to C₆ linear or branched, saturated, singly or multiply unsaturated, cyclic, aromatic, partially or fully fluorinated hydrocarbon; R³ is independently H, C₁ to C₆ linear or branched, saturated, singly or multiply unsaturated, cyclic, aromatic, partially or fully fluorinated hydrocarbon; z is 1 or 2; n is 0 to 3; p is 0 to 3; and t is 1 to 4, provided that n+p ≤ 3; and
(p) the formula (R¹ₙ(OR²)ₚ(NR³_{z})₃₋₍ₙ₊ₚ₎Si)ₜNH₃₋ₜ where R¹ is independently H or C₁ to C₄ linear or branched, saturated, singly or multiply unsaturated, cyclic, partially or fully fluorinated hydrocarbon; R² is independently C₁ to C₆ linear or branched, saturated, singly or multiply unsaturated, cyclic, aromatic, partially or fully fluorinated hydrocarbon; R³ is independently H, C₁ to C₆ linear or branched, saturated, singly or multiply unsaturated, cyclic, aromatic, partially or fully fluorinated hydrocarbon; z is 1 or 2; n is 0 to 3; p is 0 to 3; and t is 1 to 3, provided that n+p ≤ 3.

8. The method of Claim 7 wherein the at least one precursor is at least one selected from: diethoxymethylsilane, dimethyldimethoxysilane, dimethyldiacetoxysilane, methylacetoxy-t-butoxysilane, 1,3-dimethyl-1,3-diethoxydisiloxane, 1,3-dimethyl-1,3-diacetoxydisiloxane, 1,3-dimethyl-1-acetoxy-3-ethoxydisiloxane, 1,3-dimethyl-1,3-diacetoxy-1,3-diethoxydisiloxane, 1,2-dimethyl-1,1,2,2-tetraethoxydisilane, 1,2-dimethyl-1,1,2,2-tetraacetoxydisilane, 1,2-dimethyl-1-acetoxy-2-ethoxydisilane, 1,2-dimethyl-1,2-diacetoxy-1,2-diethoxydisilane, 1,3,5,7-tetramethylcyclotetrasiloxane, and octamethylcyclotetrasiloxane.

9. The method of Claim 7 or 8 wherein the hydrocarbon is at least one selected from: cyclohexane, trimethylcyclohexane, 1-methyl-4(1-methylethyl)cyclohexane, cyclooctane, methylcyclooctane, cyclooctene, cyclooctadiene, cycloheptene, cyclopentene, 1,5,9-cyclododecatriene, ethylene, propylene, acetylene, neohexane, cyclohexene, vinylcyclohexane, dimethylcyclohexene, t-butylcyclohexene, alpha-terpinene, pinene, 1,5-dimethyl-1,5-cyclooctadiene, vinyl-cyclohexene, norbornane, spiro-nonane, decahydronaphthalene, camphene, norbornene, norbornadiene, and adamantane.

10. The method of any one of Claims 1 to 3 wherein the hydrocarbon and the at least one precursor are the same molecule.

11. The method of Claim 10 wherein the at least one precursor is at least one selected from:
a) cyclic siloxanes of the formula (OSiR¹R³)x, where R¹ and R³ are independently H, C₁ to C₁₂, linear or branched, saturated, singly or multiply unsaturated, cyclic, partially or fully fluorinated hydrocarbon; and x is an integer from 2 to 8;
b) R¹ₙ(OR²)ₚ(NR³_{z})₄₋₍ₙ₊ₚ₎Si where R¹ is independently H, C₁ to C₁₂, linear or branched, saturated, singly or multiply unsaturated, cyclic, partially or fully fluorinated hydrocarbon; R² is independently C₁ to C₁₂, linear or branched, saturated, singly or multiply unsaturated, cyclic, aromatic, partially or fully fluorinated hydrocarbon; R³ is independently H, C₁ to C₁₂, linear or branched, saturated, singly or multiply unsaturated, cyclic, aromatic, partially or fully fluorinated hydrocarbon; z is 1 or 2; n is 0 to 4; p is 0 to 4; and n+p ≤ 4.
c) R¹ₙ(OR²)ₚ(NR⁴_{z})₃₋ₙ₋ₚSi-O-SiR³ₘ(NR⁵_{z})_{q}(OR⁶)_{3-m-q} where R¹ and R³ are independently H, C₁ to C₁₂, linear or branched, saturated, singly or multiply unsaturated, cyclic, partially or fully fluorinated hydrocarbon; R² and R⁶ are independently C₁ to C₁₂, linear or branched, saturated, singly or multiply unsaturated, cyclic, aromatic, partially or fully fluorinated hydrocarbon; R⁴ and R⁵ are independently H, C₁ to C₁₂, linear or branched, saturated, singly or multiply unsaturated, cyclic, aromatic, partially or fully fluorinated hydrocarbon; z is 1 or 2; n is 0 to 3; m is 0 to 3; p is 0 to 3; q is 0 to 3; n+p ≤ 3; and m+q ≤ 3.
d) R¹ₙ(OR²)ₚ(NR⁴_{z})₃₋ₙ₋ₚSi-SiR³ₘ(NR⁵_{z})_{q}(OR⁶)_{3-m-q} where R¹ and R³ are independently H, C₁ to C₁₂, linear or branched, saturated, singly or multiply unsaturated, cyclic, partially or fully fluorinated hydrocarbon; R² and R⁶ are independently C₁ to C₁₂, linear or branched, saturated, singly or multiply unsaturated, cyclic, aromatic, partially or fully fluorinated hydrocarbon; R⁴ and R⁵ are independently H, C₁ to C₁₂, linear or branched, saturated, singly or multiply unsaturated, cyclic, aromatic, partially or fully fluorinated hydrocarbon; z is 1 or 2; n is 0 to 3; m is 0 to 3; p is 0 to 3; q is 0 to 3; n+p ≤ 3; and m+q ≤ 3;
e) cyclic siloxanes of the formula (OSi(R¹)ₐ(OR²)_{b}NR³_{z})_{c})ₓ, where R¹, R² and R³ are independently H, C₁ to C₁₂, linear or branched, saturated, singly or multiply unsaturated, cyclic, partially or fully fluorinated; z is 1 or 2; a, b, and c are from 0 to 2; a+b+c = 2; and x is an integer from 2 to 8;
f) R¹ₙ(OR²)ₚ(O(O)CR³)₄₋₍ₙ₊ₚ₎Si where R¹ is independently H or C₁ to C₁₂ linear or branched, saturated, singly or multiply unsaturated, cyclic, partially or fully fluorinated hydrocarbon; R² and R³ are independently C₁ to C₁₂ linear or branched, saturated, singly or multiply unsaturated, cyclic, aromatic, partially or fully fluorinated hydrocarbon; n is 0 to 4; p is 0 to 4; and n+p ≤ 4; provided that at least one of R¹ is substituted with a C₃ or larger hydrocarbon;
g) R¹ₙ(OR²)ₚ(O(O)CR⁴)₃₋ₙ₋ₚSi-O-SiR³ₘ(O(O)CR⁵)_{q}(OR⁶)_{3-m-q} where R¹ and R³ are independently H or C₁ to C₁₂ linear or branched, saturated, singly or multiply unsaturated, cyclic, partially or fully fluorinated hydrocarbon; R², R⁴, R⁵ and R⁶ are independently C₁ to C₁₂ linear or branched, saturated, singly or multiply unsaturated, cyclic, aromatic, partially or fully fluorinated hydrocarbon; n is 0 to 3; m is 0 to 3; q is 0 to 3; and p is 0 to 3, provided that n+p ≤ 3, m+q ≤ 3, and at least one of R¹ and R³ is substituted with a C₃ or larger hydrocarbon;
h) R¹ₙ(OR²)ₚ(O(O)CR⁴)₃₋ₙ₋ₚSi-SiR³ₘ(O(O)CR⁵)_{q}(OR⁶)_{3-m-q} where R¹ and R³ are independently H or C₁ to C₁₂ linear or branched, saturated, singly or multiply unsaturated, cyclic, partially or fully fluorinated hydrocarbon; R², R⁴, R⁵ and R⁶ are independently C₁ to C₁₂ linear or branched, saturated, singly or multiply unsaturated, cyclic, aromatic, partially or fully fluorinated hydrocarbon; n is 0 to 3; m is 0 to 3; q is 0 to 3; and p is 0 to 3, provided that n+p ≤ 3, m+q ≤ 3, and at least one of R¹ and R³ is substituted with a C₃ or larger hydrocarbon;
i) R¹ₙ(OR²)ₚ(O(O)CR⁴)₃₋ₙ₋ₚSi-R⁷-SiR³ₘ(O(O)CR⁵)_{q}(OR⁶)_{3-m-q} where R¹ and R³ are independently H or C₁ to C₁₂ linear or branched, saturated, singly or multiply unsaturated, cyclic, partially or fully fluorinated hydrocarbon; R², R⁴, R⁵, R⁶, and R⁷ are independently C₁ to C₁₂ linear or branched, saturated, singly or multiply unsaturated, cyclic, aromatic, partially or fully fluorinated hydrocarbon, alternatively, R⁷ is an amine or an organoamine group; n is 0 to 3; m is 0 to 3; q is 0 to 3; and p is 0 to 3, provided that n+p ≤ 3, m+q ≤ 3, and at least one of R¹, R³ and R⁷ is substituted with a C₃ or larger hydrocarbon;
j) (R¹ₙ(OR²)ₚ(O(O)CR³)₃₋₍ₙ₊ₚ)Si)ₜCH₄₋ₜ where R¹ is independently H or C₁ to C₁₂ linear or branched, saturated, singly or multiply unsaturated, cyclic, partially or fully fluorinated hydrocarbon; R² and R³ are independently C₁ to C₁₂ linear or branched, saturated, singly or multiply unsaturated, cyclic, aromatic, partially or fully fluorinated hydrocarbon; n is 0 to 3; p is 0 to 3; and t is 1 to 4, provided that n+p ≤ 3 and at least one of R¹ is substituted with a C₃ or larger hydrocarbon;
k) (R¹ₙ(OR²)ₚ(O(O)CR³)₃₋₍ₙ₊ₚ₎Si)ₜNH₃₋ₜ where R¹ is independently H or C₁ to C₁₂ linear or branched, saturated, singly or multiply unsaturated, cyclic, partially or fully fluorinated hydrocarbon; R² and R³ are independently C₁ to C₁₂ linear or branched, saturated, singly or multiply unsaturated, cyclic, aromatic, partially or fully fluorinated hydrocarbon; n is 0 to 3; p is 0 to 3; and t is 1 to 3, provided that n+p ≤ 3 and at least one of R¹ is substituted with a C₃ or larger hydrocarbon;
l) cyclic siloxanes of the formula (OSiR¹R³)ₓ, where R¹ and R³ are independently H or C₁ to C₁₂ linear or branched, saturated, singly or multiply unsaturated, cyclic, partially or fully fluorinated hydrocarbon; and x is any integer from 2 to 8, provided that at least one of R¹ and R³ is substituted with a C₃ or larger hydrocarbon;
m) cyclic silazanes of the formula (NR¹SiR¹R³)ₓ, where R¹ and R³ are independently H or C₁ to C₁₂ linear or branched, saturated, singly or multiply unsaturated, cyclic, partially or fully fluorinated hydrocarbon; and x is any integer from 2 to 8, provided that at least one of R¹ and R³ is substituted with a C₃ or larger hydrocarbon;
n) cyclic carbosilanes of the formula (CR¹R³SiR¹R³)ₓ, where R¹ and R³ are independently H or C₁ to C₁₂ linear or branched, saturated, singly or multiply unsaturated, cyclic, partially or fully fluorinated hydrocarbon; and x is any integer from 2 to 8, provided that at least one of R¹ and R³ is substituted with a C₃ or larger hydrocarbon;
o) the formula R¹ₙ(OR²)ₚ(NR³_{z})₄₋₍ₙ₊ₚ₎Si where R¹ is independently H or C₁ to C₁₂ linear or branched, saturated, singly or multiply unsaturated, cyclic, partially or fully fluorinated hydrocarbon; R² and R³ are independently C₁ to C₁₂ linear or branched, saturated, singly or multiply unsaturated, cyclic, aromatic, partially or fully fluorinated hydrocarbon; z is 1 or 2; n is 0 to 4; p is 0 to 4; and n+p ≤ 4; provided that at least one of R¹ is substituted with a C₃ or larger hydrocarbon;
p) the formula R¹ₙ(OR²)ₚ(NH_{y}R⁴_{z})₃₋ₙ₋ₚSi-O-SiR³ₘ(NH_{y}R⁵_{z})_{q}(OR⁶)_{3-m-q} where R¹ and R³ are independently H or C₁ to C₁₂ linear or branched, saturated, singly or multiply unsaturated, cyclic, partially or fully fluorinated hydrocarbon; R², R⁴, R⁵ and R⁶ are independently C₁ to C₁₂ linear or branched, saturated, singly or multiply unsaturated, cyclic, aromatic, partially or fully fluorinated hydrocarbon; y is 0 or 1; z is 1 or 2; x+y = 1 or 2; n is 0 to 3; m is 0 to 3; q is 0 to 3; and p is 0 to 3, provided that n+p ≤ 3, m+q ≤ 3, and at least one of R¹ and R³ is substituted with a C₃ or larger hydrocarbon;
q) the formula R¹ₙ(OR²)ₚ(NH_{y}R⁴_{z})₃₋ₙ₋ₚSi-SiR³ₘ(NH_{y}R⁵_{z})_{q}(OR⁶)_{3-m-q} where R¹ and R³ are independently H or C₁ to C₁₂ linear or branched, saturated, singly or multiply unsaturated, cyclic, partially or fully fluorinated hydrocarbon; R², R⁴, R⁵ and R⁶ are independently C₁ to C₁₂ linear or branched, saturated, singly or multiply unsaturated, cyclic, aromatic, partially or fully fluorinated hydrocarbon; y is 0 or 1; z is 1 or 2; x+y = 1 or 2; n is 0 to 3; m is 0 to 3; q is 0 to 3; and p is 0 to 3, provided that n+p ≤ 3, m+q ≤ 3, and at least one of R¹ and R³ is substituted with a C₃ or larger hydrocarbon;
r) the formula R¹ₙ(OR²)ₚ(NH_{y}R⁴)₃₋ₙ₋ₚSi-R⁷-SiR³ₘ(NH_{y}R⁵)_{q}(OR⁶)_{3-m-q} where R¹ and R³ are independently H or C₁ to C₁₂ linear or branched, saturated, singly or multiply unsaturated, cyclic, partially or fully fluorinated hydrocarbon; R², R⁴, R⁵, R⁶, and R⁷ are independently C₁ to C₁₂ linear or branched, saturated, singly or multiply unsaturated, cyclic, aromatic, partially or fully fluorinated hydrocarbon, alternatively, R⁷ is an amine or an organoamine group; y is 0 or 1; z is 1 or 2; x+y = 1 or 2; n is 0 to 3; m is 0 to 3; q is 0 to 3; and p is 0 to 3, provided that n+p ≤ 3, m+q ≤ 3, and at least one of R¹, R³ and R⁷ is substituted with a C₃ or larger hydrocarbon;
s) the formula (R¹ₙ(OR²)ₚ(NH_{y}R³_{z})₃₋₍ₙ₊ₚ₎Si)ₜCH₄₋ₜ where R¹ is independently H or C₁ to C₁₂ linear or branched, saturated, singly or multiply unsaturated, cyclic, partially or fully fluorinated hydrocarbon; R² and R³ are independently C₁ to C₁₂ linear or branched, saturated, singly or multiply unsaturated, cyclic, aromatic, partially or fully fluorinated hydrocarbon; y is 0 or 1; z is 1 or 2; x+y = 1 or 2; n is 0 to 3; p is 0 to 3; and t is 1 to 4, provided that n+p ≤ 3 and at least one of R¹ is substituted with a C₃ or larger hydrocarbon;
t) the formula (R¹ₙ(OR²)ₚ(NH_{y}R³_{z})₃₋₍ₙ₊ₚ₎Si)ₜNH₃₋ₜ where R¹ is independently H or C₁ to C₁₂ linear or branched, saturated, singly or multiply unsaturated, cyclic, partially or fully fluorinated hydrocarbon; R² and R³ are independently C₁ to C₁₂ linear or branched, saturated, singly or multiply unsaturated, cyclic, aromatic, partially or fully fluorinated hydrocarbon; y is 0 or 1; z is 1 or 2; x+y = 1 or 2; n is 0 to 3; p is 0 to 3; and t is 1 to 3, provided that n+p ≤ 3 and at least one of R¹ is substituted with a C₃ or larger hydrocarbon;
u) cyclic siloxanes of the formula (OSi(R¹)ₐ(OR²)_{b}NR³_{z})_{c})ₓ, where R¹, R² and R³ are independently H or C₁ to C₁₂ linear or branched, saturated, singly or multiply unsaturated, cyclic, partially or fully fluorinated hydrocarbon; x is an integer from 2 to 8; z is 1 or 2; a, b, and c are from 0 to 2 and a+b+c = 2, provided that at least one of R¹, R², and R³ is substituted with a C₃ or larger hydrocarbon;
v) cyclic silazanes of the formula (NR¹Si(R¹)ₐ(OR²)_{b}NR³_{z})_{c})ₓ, where R¹, R², and R³ are independently H or C₁ to C₁₂ linear or branched, saturated, singly or multiply unsaturated, cyclic, partially or fully fluorinated hydrocarbon; x is an integer from 2 to 8; z is 1 or 2; a, b, and c are from 0 to 2 and a+b+c = 2, provided that at least one of R¹ and R³ is substituted with a C₃ or larger hydrocarbon; and
w) cyclic carbosilanes of the formula (CR¹R³Si(OR²)_{b}NR³)_{c})ₓ, where R¹ , R², and R³ are independently H or C₁ to C₁₂ linear or branched, saturated, singly or multiply unsaturated, cyclic, partially or fully fluorinated hydrocarbon; x is an integer from 2 to 8; b and c are from 0 to 2 and b+c = 2, provided that at least one of R¹, R² and R³ is substituted with a C₃ or larger hydrocarbon.

12. The method of Claim 11 wherein the at least one precursor is at least one selected from: 1-neohexyl-1,3,5,7-tetramethylcyclotetrasiloxane, dimethylamino-t-butoxy-neo-hexylsilane, diethoxy-neo-hexylsilane, 1,3-diethylamino-1,3-di-t-butoxy-1-neohexyldisiloxane, 1,3-diethoxy-1,3-diphenyldisiloxane, 1,2-dipropylamino-1,2-di-t-butoxy-1-neohexyldisilane, 1,2-diethoxy-1-neo-hexyldisilane, and 1,4-bis(dimethoxysilyl)cyclohexane.

13. A structure formed during manufacture of a semiconductor device, the structure comprising:
a patternable layer over a substrate;
an antireflective coating over the patternable layer, wherein the antireflective coating is represented by the formula SiᵥO_{w}CₓNᵤH_{y}F_{z}, wherein v+w+x+u+y+z = 100%, v is from 1 to 35 atomic%, w is from 1 to 65 atomic%, x is from 5 to 80 atomic%, u is from 0 to 50 atomic %, y is from 10 to 50 atomic% and z is from 0 to 15 atomic%; and
a photoresist pattern over the antireflective coating,
wherein the antireflective coating was formed by the chemical vapor deposition of (1) at least one precursor selected from an organosilane, an organosiloxane, and an aminosilane; and (2) a hydrocarbon, and wherein the hydrocarbon is substantially not removed from the antireflective coating.

14. The structure of Claim 13 wherein the patternable layer is a dielectric layer.

15. The structure of Claim 13 or 14 wherein the dielectric layer, antireflective coating, precursor and/or hydrocarbon are as further defined in any one of Claims 2 to 12.
